(19) **Europäisches Patentamt / European Patent Office / Office européen des brevets**

(11) **EP 1 159 761 B1**

(12) # EUROPEAN PATENT SPECIFICATION

(45) Date of publication and mention
of the grant of the patent:
**21.04.2010 Bulletin 2010/16**

(51) Int Cl.:
*H01L 51/05* (2006.01)    *G01N 23/00* (2006.01)
*C01B 31/02* (2006.01)    *G11C 13/02* (2006.01)

(21) Application number: **00913530.2**

(22) Date of filing: **18.02.2000**

(86) International application number:
**PCT/US2000/004220**

(87) International publication number:
**WO 2000/051186 (31.08.2000 Gazette 2000/35)**

(54) **ELECTRONIC NANOSTRUCTURE DEVICE**

ELEKTRONISCHES BAUTEIL AUF BASIS VON NANOSTRUKTUREN

DISPOSITIF ELECTRONIQUE A NANOSTRUCTURES

(84) Designated Contracting States:
**AT BE CH CY DE DK ES FI FR GB GR IE IT LI LU MC NL PT SE**

(30) Priority: **22.02.1999 US 253506**

(43) Date of publication of application:
**05.12.2001 Bulletin 2001/49**

(73) Proprietor: **Clawson, Joseph E., Jr.**
**Palmetto, Florida 342321-4213 (US)**

(72) Inventor: **Clawson, Joseph E., Jr.**
**Palmetto, Florida 342321-4213 (US)**

(74) Representative: **Harrison Goddard Foote**
**40-43 Chancery Lane**
**London**
**WC2A 1JA (GB)**

(56) References cited:
**WO-A-98/05920      DE-A1- 19 916 351**
**US-A- 5 225 089     US-A- 5 808 302**
**US-A- 5 831 166**

- **PATENT ABSTRACTS OF JAPAN vol. 1995, no. 08, 29 September 1995 (1995-09-29) & JP 07 122198 A (NEC CORP), 12 May 1995 (1995-05-12)**
- **GONDERMANN J ET AL: "New concept for ultra small N-MOSFET's" MICROELECTRONIC ENGINEERING, ELSEVIER PUBLISHERS BV., AMSTERDAM, NL, vol. 35, no. 1, February 1997 (1997-02), pages 305-308, XP004054065 ISSN: 0167-9317**

- **PH. AVOURIS ET AL.: "Carbon nanotubes: nanomechanics, manipulation, and electronic devices" NANO-SCALE MODIFICATION OF SURFACES. INTERNATIONAL SYMPOSIUM 28-30 MAY 1998 KRAKOW, POLAND, vol. 141, no. 3-4, 28 May 1998 (1998-05-28), pages 201-209, XP008049260 Applied Surface Science Elsevier Netherlands ISSN: 0169-4332**
- **K. L. LU ET AL: "Mechanical Damage of Carbon Nanotubes by Ultrasound" CARBON, ELSEVIER, OXFORD, GB, vol. 34, no. 6, 1996, pages 814-816, XP004022307 ISSN: 0008-6223**
- **MARTEL ET. AL.: 'Single-and multi-wall carbon nanotube field-effect transistors' APPLIED PHYSICS LETTERS vol. 73, no. 17, 25 October 1998, pages 2447 - 2449, XP002929419**
- **MENON ET. AL.: 'Carbon Nanotube "T Junctions": Nanoscale Metal-Semiconductor-Metal Contact Devices' PHYSICAL REVIEW LETTERS vol. 79, no. 22, December 1997, pages 4453 - 4456, XP002929420**
- **TANS ET. AL.: 'Room-temperature transistor based on a single carbon nanotube' NATURE vol. 393, no. 7, 07 May 1998, pages 49 - 52, XP002929421**
- **CHICO ET. AL.: 'Pure Carbon Nanoscale Devices: Nanotube Heterojunctions' PHYSICAL REVIEW LETTERS vol. 76, no. 6, 05 February 1996, pages 971 - 974, XP002929422**
- **PIKUS ET. AL.: 'Nanoscale field-effect transistors: An ultimate size analysis' APPLIED PHYSICS LETTERS vol. 71, no. 25, 22 December 1997, pages 3661 - 3663, XP002929423**
- **TANS ET. AL.: 'Individual single-wall carbon nanotubes as quantum wires' NATURE vol. 386, no. 3, 03 April 1997, pages 474 - 477, XP002929424**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**(Cont. next page)**

EP 1 159 761 B1

- **VENEMA ET. AL.: 'Length control of individual carbon nanotubes by nanostructuring with a scanning tunneling microscope' APPLIED PHYSICS LETTERS vol. 71, no. 18, 03 November 1997, pages 2629 - 2631, XP002929425**

Remarks:

The file contains technical information submitted after the application was filed and not included in this specification

Remarks:

## Description

## TECHNICAL FIELD

The invention is in the solid state nanostructure device and atomic microscope apparatus fields.

## BACKGROUND ART

U. S. Pat. 1,877,140 of September, 1932, to Lilienfeld and Electronic Engineering Times, November 16, 1998, p. 67, deal with nanostructures. Kasanuki et al., U. S. Pat. 5,418,771 and Yanagisawa et al., U. S. Pat. s 5,519,686 and 5,721,721, deal with atomic recording and microscope positioning technology. S. Tans et al., Nature, 3 April 1997, pp. 474-477,7 May 1998, pp. 49-52, and 20 August 1998, pp. 761-764, as well as R. Martel et al., Applied Physics Letters, 26 October 1998, pp. 2447-2449, and A. Hassanien et al., Applied Physics Letters, 28 December 1998, pp. 3839-3841, deal with so-called nanotube "transistors" with a bulk silicon gate. L. Venema et al., Applied Physics Letters, 3 November 1997, pp. 2629-2631, show a way of cutting nanotubes in situ. Z. Ren et al., Science, 6 November 1998, pp. 1105-1107, show a method of making large numbers of free-standing, aligned, and spaced carbon nanotubes.

JP 07122198 discloses a device comprising a source electrode and a drain electrode on opposed ends of an evacuated carbon nanotube such that when a voltage is applied between the source and drain electrodes, electrons pass through the vacuum controlled by a voltage applied to the carbon nanotube, so that the device can be used as a transistor.

J. Gondermann, et al. (Microelectronic Engineering 35 (1997) 305-308.) describe ultra small n-MOSFETs based on a faceted silicon wire.

## DISCLOSURE OF THE INVENTION

It is therefore an object of the present invention to provide a manner of using nanotubes to provide devices of improved areal density, speed, stability, and uniform characteristics.

It is further an object of the present invention to provide a nanoswitch which can be made by using only slightly modified existing apparatus technology to manipulate nanotubes and other nanostructures to be positioned to within a few Angstrom of where they are desired.

It is further an object of this invention to provide complementary switching devices on the same nanotube without any conventional "doping" or other structural modification to the nanotube per so.

It is a further object of this invention to produce a gating structure which will produce a localized electric field having a substantial field component directed along the nanotube longitudinal axis.

It is further an object of this invention to produce a nanoinverter circuit, analogous to that of the CMOS silicon circuit, to efficiently process signals.

It is further an object of this invention to produce a nanomultivibrator, or flip-flop, circuit analogous to that of the CMOS silicon circuit of the same name to efficiently process signals.

It is further an object of this invention to produce a nanomultivibrator, or flip-flop, count down chain to provide a means of quickly counting extremely high frequency pulses.

It is further an object of this invention to produce nanoswitches having a sharp, unparalleled high slew rate for switching, perhaps several thousand times faster than those of conventional silicon.

It is further an object of this invention to provide a high power switch and housing having unprecedented high slew rates and power handling capabilities.

It is still further an object of this invention to provide a structural manner of compensating for the RC time constant gating lag in a power nanoswitch device so that the entire device will conduct at the same instant, thus providing an extremely high slew rate.

It is still further an object of this invention to provide a structural manner of compensating for the RC time constant gating lag in a power nanoswitch device so that essentially the entire device will conduct and essentially the entire device will shut-off at the same instant for each operation, thus providing a very high slew rate for both operations.

There is also described a novel atomic microscope probe design capable of attracting and depositing nanometer sized objects in a highly precise manner.

There is also described a novel manipulating apparatus head assembly for conventional atomic positioning microscopes so that an apparatus capable of picking up the device elements and carrying, manipulating, positioning, and depositing these device elements to extremely close positional tolerances, on the order of an A, is achieved using only slightly modified existing positioning apparatus technology.

There is also described an apparatus and method of separating, selecting, straightening, and cutting nanotubes to enable the other invention objects to be carried out.

According to the invention, there is provided an electronic nanodevice as claimed in claim 1.

Further embodiments of the invention are included in the dependent claims.

Additional objects, features, and advantages of the various aspects of the present invention will become apparent from the following description of the preferred embodiments, which description should be taken in conjunction with the accompanying drawings.

## BRIEF DESCRIPTION OF THE DRAWINGS

Figure 1A shows a cross-section of conventional construction for one embodiment of a switching device using a nanotube with a bulk silicon gate, and Figure 1B shows the voltage-current characteristics thereof.

Figures 2A, 2B, and 2C show the present invention, as determined by the inventor, for a nanotube operating with a barrier having relatively high electron affinity under conditions of zero, positive, and negative biasing respectively.

Figures 3A, 3B, and 3C show a first preferred embodiment of the invention comprising a conducting nanotube and crossed gating member in isometric and cross sectional views, and the operating characteristics thereof, respectively.

Figures 4A, 4B, 4C, and 4D show a second preferred embodiment of the invention comprising a conducting nanotube with a surrounding gating material structure in isometric and cross sectional views, and three operational characteristics thereof, respectively.

Figures 5A, 5B, 5C, 5D, and 5E, show various process steps for making a nanotube inverter of the second preferred embodiment.

Figures 6A and 6B show a single nanomultivibrator, NMV, and a frequency dividing nanomultivibrator chain construction, respectively.

Figure 7 shows an isometric view of the end of a single conducting nanotube to be used in a power nanoswitch in a first preferred embodiment.

Figure 8A is an isometric view of the final power nanoswitch and housing with the top contact slightly exploded in a first preferred embodiment; Figures 8B and 8C show isometric and cross-sectional views, respectively, of second and third embodiments of a power nanoswitch with a second turn-off gating structure.

Figure 9A is a schematic of the equivalent gating circuit of the power nanoswitch, Figures 9B, 9C and 9D show suitable gating pulse shapes.

Figure 10 is a side view of a conical transportation probe and Figure 11 shows a side view of an elongated transportation probe

Figure 12A shows an isometric view of a nanotube separation and alignment tank according to the invention, while Figure 12B shows a flat plate version of the same.

Figure 13 shows an apparatus for assembling and manipulating the nanoelements to form a nanostructure under computer control.

## BEST MODE FOR CARRYING OUT THE INVENTION

When the term "nanotube" is used, this will be construed to not only include carbon nanotubes, but those made of BN, $MoS_2$, and any other material or composition capable of forming such structures having the appropriate electrical and mechanical properties.

A "nanostructure" will be any construed as any protein, chemical molecule, polymer, or any other structure of the order of the nanometer in at least one dimension. The conventional hexagonal graphene chiral vector indices for nanotubes are used, such as in M. Dresselhaus et al., Science of Fullerenes and Carbon Nanotubes, © 1996, Academic Press.

While nanostructures are capable of being understood perfectly only through the use of quantum mechanics, this involves extensive calculation and in many instances is not needed to understand the invention. Thus while the invention will be explained in conventional electrostatic terms for ease of use and understanding of the invention and in many cases this will be sufficient, the ordinary worker will appreciate that the invention can be easily recast into quantum mechanical formalism where ever necessary.

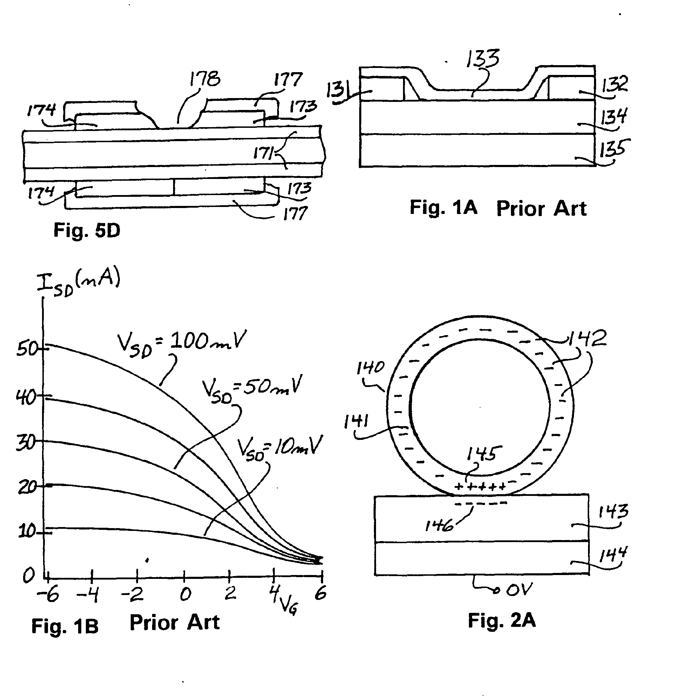

The Prior Art nanodevice at Figure 1A has some perplexing characteristics as shown at Figure 1B. The explanation by R. Martel et al., and A, Hassanien et al., *supra*, that this is a device whose conduction is through "holes" does not adequately comport with the data. Most especially troubling is the experimental observation that as the gating voltage $V_G$ becomes more and more negative, that the source-drain conduction current $I_{SD}$ continues to increase for *all* source-drain $V_{SD}$ voltages. Further, the off-hand explanation of "holes" is perhaps misleading. In silicon, an acceptor atom is "doped" to the silicon thus forming a mobile positive charge, but with charge neutrality of the silicon and the localization of the "holes." Here, since there is no actual "doping" of the nanotube, these "holes," if they exist at all, would be due to an actual charge imbalance in the nanotube, whose equilibrium would imply a very complicated and global solution of the electrical field equations, which would significantly change with the slightest biasing and would not lead to a clear understanding of how to use them in a useful manner.

Most importantly, however, since the nanotube has conducting electrons, upon close inspection these results are *exactly opposite* to what one would expect for the analogue depletion mode N-channel insulated gate field effect device in silicon that this device resembles. As seen below, the exact nature of this anomalous, but apparently unresolved result, will be explained in a model which more closely approximates the actual forces at play and more completely explains these anomalous results, and thus forms the basis for the model for this invention.

Figure 2A shows the novel analysis cross section of a nanotube under no gate bias, i.e, $V_G = 0$ according to this model. From the inventor's analysis, here one sees the outer portion of the nanotube 140, the inner portion 141, the inherent free conduction electrons 142 of the conducting nanotube 140, the barrier material 143 acting as a gate insulator, and the gate electrode per se 144 connected to a source of gating potential $V_G$. The electron affinity, $\chi_B$, of the gate barrier material 143, here an insulator, is quite critical and apparently is sufficient to fully deplete the electrons from the conducting nanotube 140 where it contacts 143 according to the inventor's analysis. Here about 8Å of the nanotube circumference contacts the barrier material 143. Whenever a material rich in conduction electrons such as the nanotube contacts a barrier material having a sufficiently high electron affinity, $\chi_b$, then electrons such as 146 will be drawn from the nanotube conductor 140-141-142 and be locally bound or trapped at the surface of contact, indicated here as 146 according to the inventor's analysis. This can leave behind fixed, immobile positive charge centers 145. A barrier material 143 surface having high electron affinity, $\chi_b$, will, of course, induce greater attraction and thus more flattening and more charge transfer than one having a lesser electron affinity. The point is that for even small diameter conducting nanotubes 140, there will always inherently be a finite flattening and intimate interaction with the gate barrier material 143 it lies on in this model. In the above example, the tube is close to a (10,10) in size and thus a contact area of about 8Å would be expected on the sufficiently large electron affinity, $\chi_b$, barrier material insulator $SiO_2$, $SiO_2$ has been notorious in the silicon field for the many dangling bonds inherent in its amorphous structure and has an electron affinity, $\chi_b$, of about 0.9-1.0eV.

typically one conventional way of passivating $SiO_2$ to remove these dangling bonds is to use hydrogen as a passivant; here the hydrogen offers up its electron to complete the bonds left unfinished by the $SiO_2$, thus forming a resultant composition commonly designated as $SiO_2$:H. This reduces the electron affinity, $\chi_b$, of the $SiO_2$:H to below that of untreated $SiO_2$. Another even more effective way of removing the dangling bonds and reducing the electron affinity, $\chi_b$, from $SiO_2$ is to use a fluorine treatment to react with any of the dangling bonds, this resultant product being commonly designated $SiO_2$:F. Especially this latter changes a normally relatively high electron affinity barrier material, $SiO_2$, into one having a relatively low electron affinity, because all the electrons at these dangling bonds will be firmly bound to the fluorine. Thus the electron affinity, $\chi_b$, for fluorinated barrier layer materials is quite low.

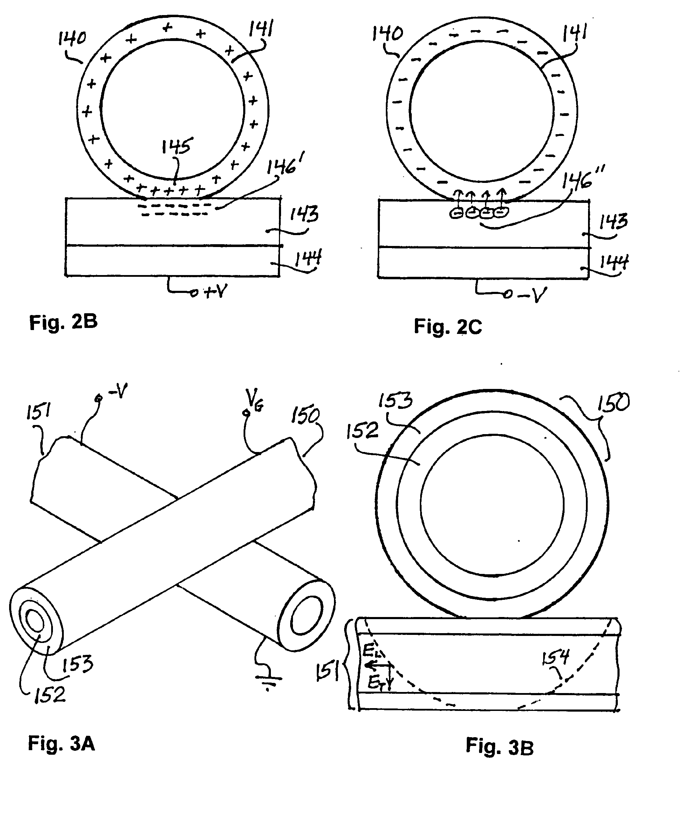

Thus Figure 2A shows that perhaps 8% or so of the available electrons in the conducting nanotube 140 are trapped at the barrier layer insulator 143/nanotube 140 interface as indicated by 146 and are thus not mobile and do not contribute to conduction. In Figure 2B, however, a positive voltage is put to the gate member 144 of the device. Here, the free electrons 142 in the conducting nanotube 140 are drawn to the positive voltage and under the highest positive voltage, virtually all the free conduction electrons 146' are trapped at the interface between 140 and 143, and thus conduction drastically decreases. The application of a positive voltage to the gating member 144, then, under this model leads to the counter-intuitive experimental result that conduction goes down, as is shown experimentally in Figure 1B.

Applying a negative voltage to the gating member 144 as at Figure 2C shows just the opposite effect; the applied gating voltage overcomes the inherent electron affinity, $\chi_b$, of the barrier layer insulator material 143 to eject the trapped electrons 146" back into the conducting portion of the nanotube 140 and thus increases the number of electrons available for conduction in nanotube 140. Indeed, this is shown at Figure 1B where the conductivity increases about 8% or so upon the application of a $V_G$ = -6V bias to gating member 144 for a source-drain $V_{SD}$ bias of 100mV. Application of a relatively high negative voltage is thus not seen to pinch off the conduction channel, as would be expected in a conventional silicon circuit, due to the fact that the conducting nanotube 140 and the gate are substantially co-linear and there is no longitudinal electric field component in the direction of the nanotube axis by which electrons may be removed. Thus, by symmetry, no "pinch-oft" can be effected. The electric field is entirely normal to the gating insulator 143 surface over its almost entire extent, thus providing no "escape" for the electrons in the conducting nanotube 140.

The nanoswitch then acts as a highly non-optimized pseudo P-channel depletion mode switch even though the conduction is not with holes, in this model, but with electrons. It is called "pseudo" because it externally acts like a silicon P-channel device, even though the actual internal workings according to this charge trapping model are quite different. Again, this is counter-intuitive to that which might be expected for a silicon device, but shows important features and differences from that of the conventional silicon structure discovered by the inventor: carbon nanotubes can act as an equivalent pseudo P-channel silicon device when there is a barrier layer between the conducting nanotube and the gating member structure having a sufficiently high electron affinity, $\chi_b$, to deplete the mobile carriers from the conducting nanotube. Nanotubes, following the teachings of the invention, can do this as well, but by merely by changing the electron affinity, $\chi_b$, of the barrier material at the gating member/nanotube interface at selected locations. Thus a single nanotube can be constructed with two blocking regions of different electron affinity, $\chi_b$, and have all the advantages of the complementary silicon device in a much more compact arrangement. In silicon, a well region of the opposite conductivity has to be made; this is totally eliminated in nanotube technology in accordance with the invention. Thus while a silicon CMOS inverter, for instance, might have a chip area ~ $\mu m^2$, a nanotube inverter might have a size area ~4nm$^2$, a difference of 250,000 times smaller area. This is felt to be a significant improvement in device density.

The gating member and the particular design of the blocking layer between the gating member and the conducting nanotube of the invention can be any of several equivalent constructions, depending upon the particular materials desired to be used in the construction.

For purposes of illustration, a first embodiment in the form of an N-channel depletion mode nanotube switch is proposed as at Figures 3A, in isometric form, and at Figure 3B, in cross section along the conducting nanotube 151, as shown. This term "conducting nanotube" is used to denote a nanotube which is capable of being biased by a potential difference, +V and Ground, or equivalently Ground and -V, at removed portions of the conducting nanotube 151 and through which a conduction current may pass, the modulation of such a conduction current being controlled by a gating structure 150, to which a suitable control voltage $V_G$ is to be applied. The "conducting nanotube" 151 may be one of several different constructions, as noted below, and is not limited to the "metallic" nanotubes; it can also be a single wall or a multiwall nanotube. A second, gating nanostructure 150, which can also comprise a nanotube, and having different characteristics from the first conducting nanotube 151, is crossed with the first conducting nanotube 151. It also can comprise a single wall or multi-wall nanotube.

Here in this first preferred embodiment, the different properties, such as the control of the blocking layer electron affinity, $\chi_b$, belong to and are associated with the gating member 150.

This is illustrated at Figures 3A and 3B where conducting nanotube 151 is crossed with gating member 150 which member can comprise either a single structure 150 or a composite structure comprising one or more inner layer nanostructure(s) 152 and an outer layer of barrier material of predetermined electron affinity, $\chi_b$, 153 around its outer periphery, the composite structure of 152 and 153 also referred to together as gating member 150.

A barrier material 153, including a high electron affinity, $\chi_b$, barrier layer material, can create a good N-channel depletion mode device since the contact depletion area between conducting nanotube 151 and gating member 150 is so small as to be neglected in this construction. If, for instance, the barrier layer material 153 is conductive, such as a Schottky forming metal, or a semiconductor, or a doped semiconductor, or a combination of semiconductor layers, then it can be used with an inner gating structure nanotube 152 even though the barrier material of 153 has a high electron affinity, $\chi_b$, and may completely deplete the carriers from that inner nanotube 152. In this case, the inner gating member nanotube 152 acts as a non-conducting structural support member or mandrel for this high electron affinity, $\chi_b$, barrier layer material 153 in the gating member structure 150.

One particular combination of a high electron affinity, $\chi_b$, material useful in gallium arsenide (GaAs) integrated circuits is the use of a combination layer of undoped GaAs over the inner nanotube 152 and an outer layer of N+ doped AlGaAs over the undoped GaAs layer. This produces a two dimensional electron gas, "2DEG," just inside the GaAs at the GaAs/AlGaAs interface and provides a highly conductive means by which the gating potential signal $V_G$ to the gating member 150 can be propagated down the gating structure 150. This, then, can form one of many "bridges" between a GaAs integrated circuit and a nanotube integrated circuit. Alternatively, the highly doped N+ AlGaAs layer can contact the inner nanotube 152 and the GaAs layer be on the outside of the N+AlGaAs. Further, such nanotube/GaAs(N+Al-GaAs)/N+AlGaAs(GaAs) combinations could have utility in their own right as completely compatible conductors for power and signals in a hyperfine GaAs integrated circuit by itself.

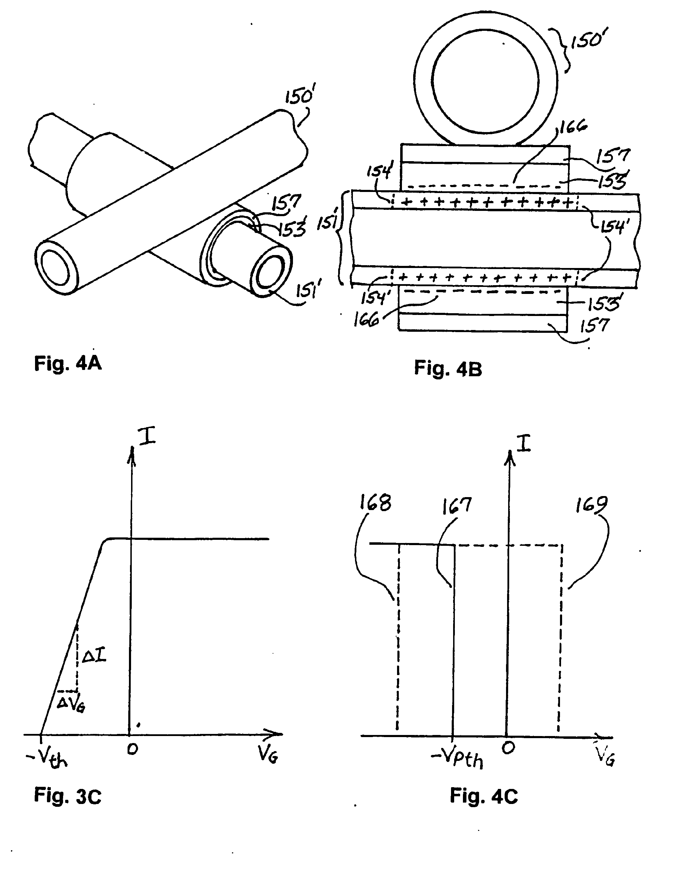

If, as is shown at Figures 3A and 3B, the barrier layer material 153 of the gate member 150 has an electron affinity, $\chi_b$, sufficiently small so as to not completely deplete the electrons from a nanotube and has a sufficient barrier height for gating isolation purposes, then a successful depletion mode N-channel nanoswitch can also be had with a much wider range of materials. Here the conducting nanotube 151 will hardly notice the presence of this low electron affinity barrier layer material portion 153 of the gating member 150 when there is zero biasing voltage $V_G$ put to the gating member 150. The electrons in the conducting nanotube 151 are then free to conduct as well as the electrons in the gating member 150. When a sufficiently negative gating voltage $V_G$ is put to the gating member 150, however, by Coulomb electrostatic repulsion, the electrons in conducting nanotube 151 will be repelled and depleted in the region illustrated as 154 in the entire area adjacent to the contact between the conducting nanotube 151 and the gating structure 150 and current flow in the conducting nanotube 151 will cease. This transfer characteristic is shown at Figure 3C, where at a negative gating voltage $V_G$ = -$V_{Nth}$ the conducting channel pinches off at this threshold voltage and the conduction stops. The slope of the I/$V_G$ curve at -$V_{Nth}$, the "switching slew rate" of the gate, $_\Delta I/_\Delta V_G$, is moderately sharp as only an extremely small gating voltage $V_G$ difference is needed to fully deplete the conducting nanotube 151 diameter. A point of difference here to the prior art is that the entire conducting portion of the gating structure 150 produces an electrostatic surface which has an electric field E at the depletion layer surface 154 having a longitudinal component $E_L$ along the conducting nanotube 151 longitudinal axis and a transverse component $E_T$ normal to the longitudinal axis. The simplicity of this design is that it can be made completely of elemental carbon nanotubes, all of which have been made for years by laboratories throughout the world. If the conducting nanotube 151 is a semiconducting nanotube of bandgap $g_1$, then the gating structure 150 can be another semiconducting nanotube, for instance, with a second bandgap $g_2$ significantly different from $g_1$, $g_1 \neq g_2$. Thus for an N-channel depletion mode nanoswitch a wide range of combinations of true metallic, metalloid, or semiconductor nanotubes can be used, including the conductive nanotube 151 and the gating structure 150, and a wide range of materials can also be used for the barrier material 153, the only provision being that the barrier between the conducting nanotube 151 and the gating member 150 have a sufficient barrier height to provide a usable gating voltage $V_G$ to the gating member 150 to fully deplete conducting nanotube 151 without breakdown or adverse leakage.

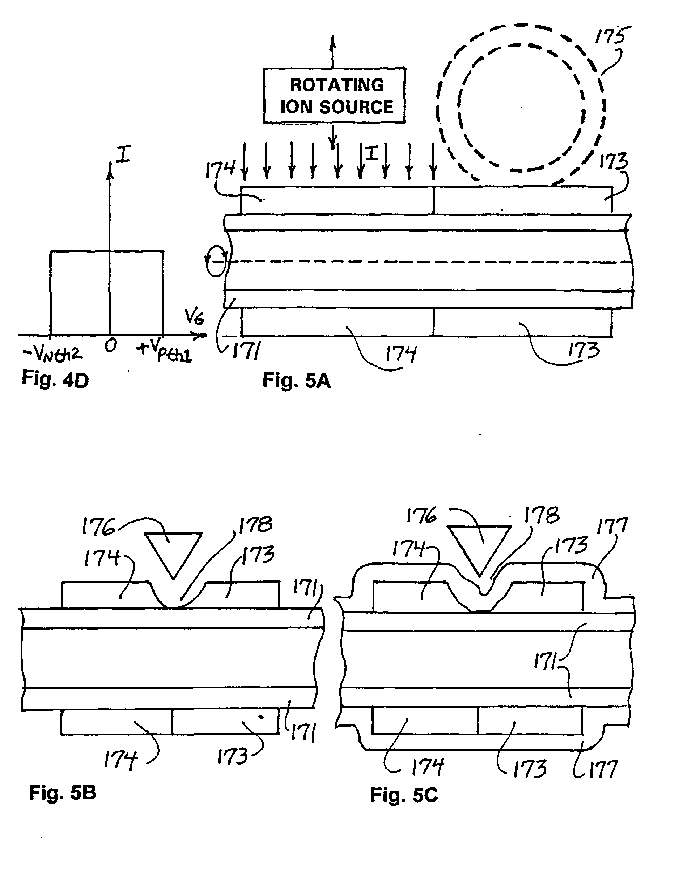

As above noted, the structural design of Figures 3A and 3B is not well suited for a pseudo P-channel nanoswitch, basically because of the small area of contact between the conducting nanotube 151 and the barrier material 153 of the gating structure 150. One solution, of course, is to increase the level of contact of the barrier material with the conducting nanotube, such alternative construction shown at Figures 4A and 4B. It is preferred in this embodiment that the barrier material 153' substantially surround or completely surround a region of the conducting nanotube 151' to give the device this sufficient contact area. If the barrier material 153' is not inherently sufficiently conductive to form an equipotential surface when contacted by gating member 150', an additional conductive layer 157 can be added to surround the barrier material 153' and the conductive nanotube 151'. For many materials, such as Schottky barrier materials which are inherently sufficiently conductive as noted above, this added conductive layer 157 may be unnecessary and preferably is omitted as long as the gating member 150' can make ohmic contact to the conductive Schottly barrier material 153'. The gate threshold voltage $V_G = -V_{Pth}$ is a direct result of the workfunction $\emptyset_b$ of the particular barrier material 153'. The only requirements here for this barrier gating material 153' is to have a sufficiently large electron affinity, $\chi_b$, to at least partially deplete the conducting nanotube 151' at zero gating bias $V_G$ whether the conducting nanotube 151' is a true metallic, a metalloid, or a semiconducting nanotube, and with sufficient barrier height so that a practical potential barrier can be established sufficient to undeplete the conducting nanotube 151' at a proper gate voltage $V_G = -V_{pth}$ as is shown by switching curves 167, 168. A further pseudo P-channel nanoswitch, a depletion mode device, may also be made using this construction of Figures 4A and 4B. If the barrier material 153' is able to trap electrons but has an electron affinity, $\chi_b$, which is insufficient to deplete, or fully deplete, the electrons from the conducting nanotube 151' at zero gating bias $V_G$, then by applying a positive gating potential $V_G$ to the gating structure, this positive potential may be able to assist the barrier material 153' to then trap the free electrons in the barrier material 153' and thus pinch off the conducting nanotube 151'. This case is shown with the dashed curve 169 at Figure 4C. Thus a device of narrow conduction can be had as at Figure 4D.

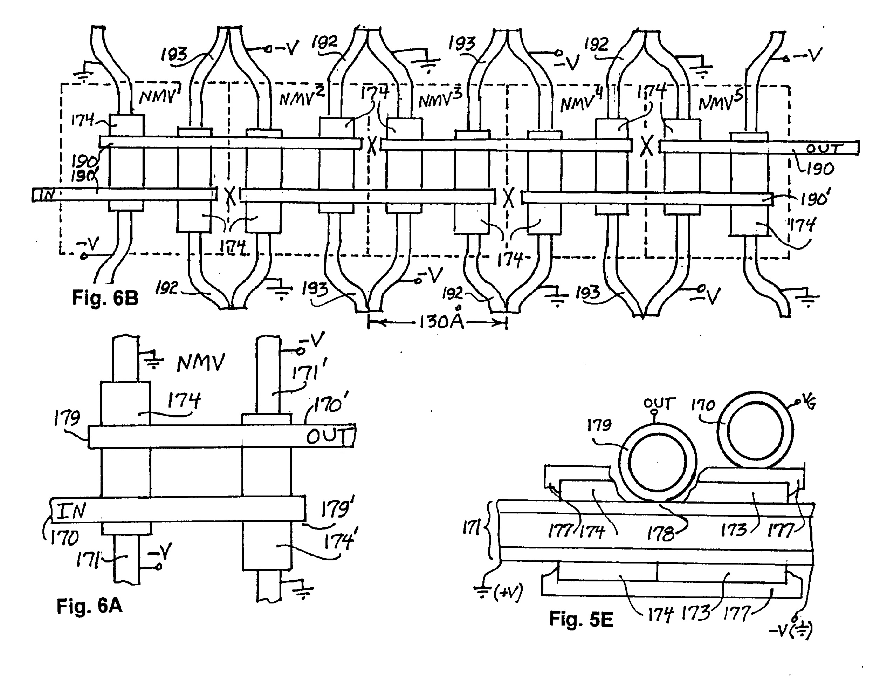

These are all the elements needed to form a pseudo "CMOS" nanotube switching pair inverter which can have all the advantages of the silicon CMOS pair where the gates of the N-channel and pseudo P-channel nanoswitches are connected together to the same negative $V_G$ switching signal, one way as at Figure 5A. Here a beginning nanotube 171 is coated with a beginning barrier material layer 173 which has a sufficient electron affinity, $\chi_{b1}$, to deplete the beginning nanotube 171 of carriers at zero external potential bias, a material which has been discussed as above. A masking, dummy nanotube 175 of suitable lateral width is then placed over a portion of this beginning barrier material layer 173 as illustrated at Figure 5A. An ion-implantation of a particular ion is then done to convert the beginning barrier material layer 173 into a second barrier material layer 174 having a second electron affinity, $\chi_{b2}$, which is insufficient to deplete the conducting nanotube 171 of carriers at zero biasing potential, as discussed above, at the unmasked portions. Since it is preferred that this second barrier material layer 174 completely surround, or at least substantially surround, the conducting nanotube 171, this can be done by moving the ion source in a 180° arc using the longitudinal axis of the conducting nanotube 171 as an axis of rotation. Thus by using the temporary nanotube 175 as a mask and implanting the desired ions in such a 180° arc, virtually all of the unmasked portion of the initial barrier material layer 173 is converted to the new material 174. One particular example of this is to use uncompensated $SiO_2$ as the beginning barrier material 173, which as noted above has sufficient electron affinity, $\chi_{b1}$, to deplete carriers from the conducting nanotube 171, as has been previously noted. If hydrogen, H+, or fluorine, F-, ions are then implanted into the unmasked portion and suitably heat treated, as in conventional silicon processing, then that barrier material portion 174 will have a second electron affinity, $\chi_{b2}$, which is insufficient to deplete the carriers from die conducting nanotube 171, as previously discussed. Here, since the barrier material layers 173 and 174 are insulators having different surface properties they are detectable and the transition between the two is detectable by a Tunneling Electron Microscope ("TEM") probe 176 as is illustrated at Figure 5B. It is well known in the art that a voltage put to such a probe can, depending upon the applied voltage pulse, e.g. less than 4 volts, generate a high enough electric field to clear away the insulator 173-174 at this transition portion 178 as is shown at Figure 5B. The entire assembly can then be overcoated by a conductive coating 177 and the TEM probe brought back as at Figure 5C where the probe 176 can again detect the transition portion 178 and can blast the conductive coating away at this portion 178 with a voltage pulse. A bias can then be put to the conducting nanotube 171, the tube assembly put into an electroetchive bath, and the portions of the conductive layer 177 which are in direct contact with the conductive nanotube 171 will etch away first, leaving a conductive coating 177 only over the barrier material portions 173 and 174, as is shown at Figure 5D. One alternative variation of this process is to use an appropriate Schottky forming metal for the initial barrier material 173. Here ions of another type of metal can be then implanted into the exposed portion of 173 at Figure 5A to alter the alloy composition thereof. The gating member 170 corresponds to that of 150 and 150' of Figures 3A - 4B and, due to the coextensive nature of the conductive overlay 177, forms the common gate of the N-channel depletion mode nanoswitch 171-174-177 and the pseudo P-channel enhancement mode nanoswitch 171-173-177. Thus at Figure 5E the conductor nanotube 179 contacts the conductive nanotube 171 at the node between the P and N-channel devices and forms the output signal of the inverter, the conductor 177 forms the common gating connection, and the gating member 170 forming the signal input. Thus a very compact pseudo CMOS type inverter can be made using all of the same type of conducting nanotube 170 without any doping of the conductor member and done in a very compact arrangement, the entire length kept to about 50Å or so.

Using this CMOS-like nanoinverter of Figure 5E, it is a simple matter to form a cross-coupled nanomultivibrator, NMV, (flip-flop). One can take two of the nanoinventers of the construction of Figure 5E and rotate one of them 180° with respect to the other such that the gating and output connections are aligned as at Figure 6A. Here the nanoinverter at the left has the same designations as that of Figure 5E. The rotated nanoinverter at the right has the same designations, only primed ('). Thus the input conductor nanotube 170 of the nanoinverter on the left is connected to the common node of the nanoinverter on the right, 179' and a single conductor nanotube 170-179' then forms this essential cross-coupling. In a likewise manner, the common node connection 179 of the nanoinverter on the left is cross-coupled connected to the output gating 170' of the nanoinverter on the right. While the terms "-V" and Ground are used to denote the potentials to the various regions it is to be noted that they can equally be considered to be Ground and +V, respectively, this being a change only in what one chooses to call a "ground." Since the gating voltages here are negative to achieve the desired switching, then the first designation, Ground and -V, may be more accurate. However, since conventional engineering has used +V and Ground, for such CMOS inverters, this designation can also be used equivalently.

If one uses a (10,10) metallic nanotube for the initial conducting nanotube 171, adds a barrier layer 173-174 of about 30Å thickness, and a final conductive coating 177 of about 10Å, then the inverter of Figure 5E will have a diameter of about 50Å and can be about 50Å long. Assuming a spacing between the two nanoinverters of about 15Å, one has a cell pitch of about 130Å x 75Å, or about 100nm$^2$ in total area for the nanomultivibrator, NMV. This is perhaps a factor of $10^8$ smaller in volume than any multivibrator currently being made.

An estimate can be made of the performance of the nanomultivibrator. Since the capacitance, C, of a conductive wire above a conductive substrate can be shown, e.g. at W. Scott, The Physics of Electricity and Magnetism, 2nd Edition, © 1966 Wiley, New York, pp. 163-165, to be:

$$C = 2\pi\varepsilon_o L / \ln\{(d + (d^2 - R^2)^{\frac{1}{2}})/R\}$$

where $\varepsilon_o$ = 8.85 x $10^{-12}$ F/m, d = 25Å is the distance from the conductor axis to the plane, R = 6.5Å is the conductor radius, and considering the length of the nanoinverter at = 50Å and the length of the output line to the other inverter at ≈ 130Å, then a total capacitance, C, of the one nanoinverter node becomes C = 2 x $10^{-18}$ F. Considering that the tested resistance of such nanotube conductors is in the range of 400 - 750 Ω/Å of length on a macroscopic average, then the 180Å total inverter and output resistance length results in an RC time constant on the order of RC.≈ 0.1-0.3 x $10^{-12}$ sec., or in the sub picosecond range, somewhat faster than current silicon devices. This estimate has been independently corroborated by calculations of A. Johnson at the 1999 I.S.S.C.C., and others for similar structures.

A plurality of such nanomultivibrators, NMV, as in Figure 6A can easily be combined in a chain to form a count-down frequency divider. If one takes the basic design of Figure 6A and forms an adjacent multivibrator unit of a mirror image construction, then this will result in like pairs of adjacent conducting nanotubes having the same power supply connection as at Figure 6B with a plurality of such mirror-reversed nanomultivibrators, NMV$^i$, in a counting chain, except for the end nanoinverters. One can then put two long conductor nanotubes 190 and 190' over the regions corresponding to the nodes and input/output connections. To form the cross-coupled connections for each nanomultivibrator, NMV, merely bring back the TEM probe and go to every fourth space between the conducting nanotubes 190 and 190' and apply a voltage, ranging from 4 to 6.5 volts, to it which is sufficient to sever the nanotube 190, 190' at that point. See, for example, L. Venema et al., Length control of individual carbon nanotubes by nanostructuring with a scanning tunneling microscope, Applied Physics Letters, Vol. 71, No. 18, 3 November 1997, pp. 2629-2631. This cutting is marked with an "X" in the drawings. Thus rather than bring in short sections of nanotubing to form the cross-coupled connections corresponding to 190, 190', single long sections can be used and then broken in situ as desired and as indicated. Thus, applying the input signal to the input and the appropriate power supply voltages, one can have a nanomultivibrator, NMV, frequency dividing chain of any desired length in a space far smaller than is possible with any techniques today.

It will be appreciated that power devices play an important role in the electronics industry and that devices having extremely high switching slew rates are currently quite useful in such areas as telecommunications and power transmission. Using the design of the pseudo P-channel device of Figures 4A and 4B, however, one can readily adapt this design to that of a power device.

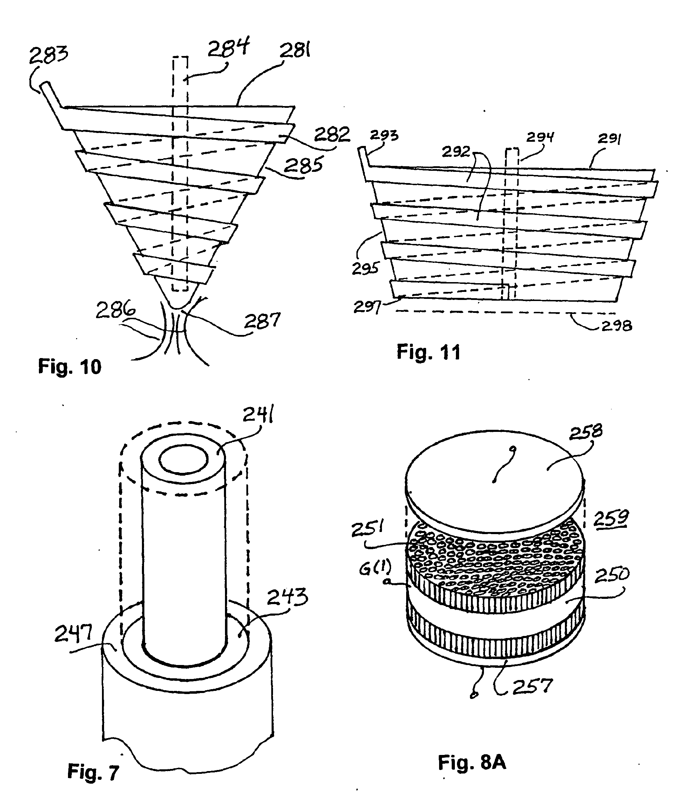

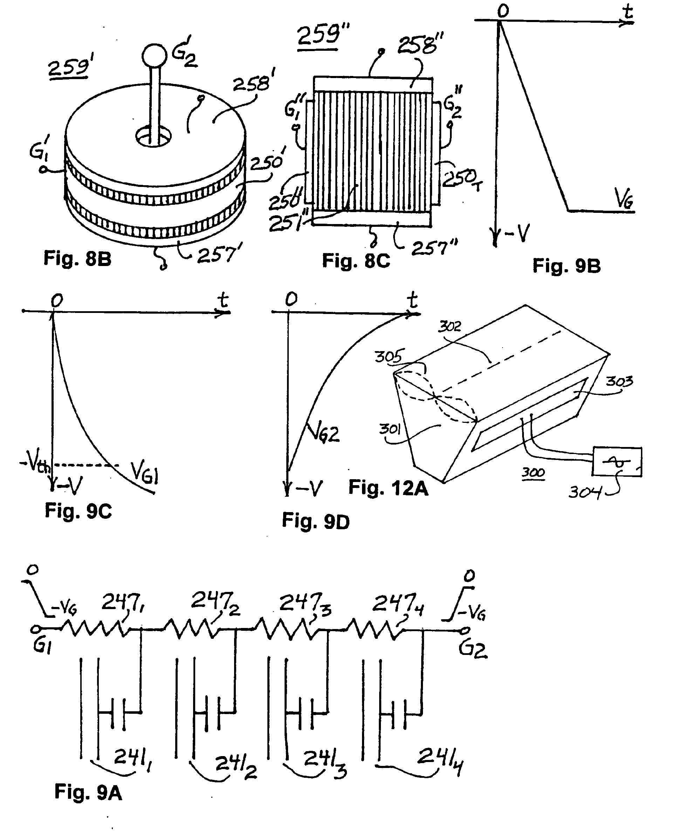

Conducting nanotubes can be used to have all the advantages with none of the disadvantages associated with the conventional silicon technology for such a proposed power device. If a plurality of conducting nanotubes, ranging from several, to dozens, to hundreds, to millions, to hundreds of billions, whether they are true metallic, metalloid, or semiconducting, are placed in parallel and suitably gated, then a power device can be constructed. The chief object of the gating member 150' in Figures 4A and 4B is to provide a potential to a single conducting ' nanotube 151'. By merely connecting a plurality of nanoswitch tubes together in parallel with a common gating and common end connections, a nanoswitch of lowered ON resistance and increased power handling capability is enabled. In the very large power device embodiment of Figure 8A, the gating is to be done macroscopically throughout the power device, so many of the particular limitations and restrictions on the gating member 150' of Figures 4A and 4B can be relaxed.

This modification of the nanoswitch of Figures 4A and 4B to a very large power device structure is shown beginning at Figure 7. Conducting nanotube 241, whether it is a true metallic, metalloid, or semiconducting nanotube, is surrounded by a barrier material 243 and a conductor 247. If barrier material 243 is a conductor, then 243 and conductor 247, if it is used, are preferably recessed at the ends of conducting nanotube 241. Otherwise if barrier material 243 is a dielectric insulator, it can be made flush with the ends of the conducting nanotube 241. As with the embodiment of Figures 4A and 4B, the barrier material 243 can be any Schottky forming material, or insulator, or semiconductor material, including III-Vs and II-VIes, of whatever kind and doping, etc., such that the electron affinity, $\chi_b$, of the barrier material 243 is sufficient to deplete or at least partially deplete the conducting nanotube 241 at zero gating potential $V_G$ while providing sufficient gating barrier height to provide a usable gating function for a gating control voltage $V_G$. Conductive material 247 need only provide a gating potential surface to the barrier material 243 and can, in some instances, be part of the barrier material 243. The only requirement is that the conductive material 247 or, if used alone, the barrier material 243 be sufficiently conductive to provide a relatively low gating RC time constant for the gating signal $V_G$ and can form part of the Schottky barrier material if the Schottky barrier is chosen. However, as will be separately shown below, even this RC time constant requirement can be compensated for as well to effectively null-out any such RC time constant delays in a very large power device to enable all the elements of the power switch to completely switch at the same instant, thus providing a power switch of unprecedentedly high switching slew rate.

While there are, of course, many different methods of making carbon nanotubes, and this invention is not directed to such processes per se, some of the processes result in tangled ropes of nanotubes and these processes are not directly applicable to being used with most of the invention. However, one example of compatible processes which has great applicability to all the modes of the invention practiced here is that of Z. Ren et al., Synthesis of Large Arrays of Well-Aligned Carbon Nanotubes on Glass, as appeared in Science, Vol. 282, No. 5391, 6 November 1998, pp. 1105-1107. Here free-standing aligned and spaced carbon nanotubes are grown up to several square centimeters at a time on a nickel-coated glass substrate. Especially Figure 3B thereof shows essentially a forest of spaced nano-telephone poles. This particular process, which has the nanotubes separated, makes possible the use of standard silicon processing technologies such as Chemical Vapor Deposition ("CVD") techniques for a variety of dielectric, semiconductive, and conductive materials as are used herein. Any prior art method which provides for the separate formation of the nanotubes so they can be treated with conventional silicon technologies is applicable here. Using such a nanotube creation method allows for the later formation, for example, of an uncompensated $SiO_2$ or $SiO_x$ barrier material 243 on the surfaces of the carbon conducting nanotube 241 using wholly conventional silicon processing technology.

In practice, any number, from several, to dozens, to hundreds, to millions, to hundreds of millions of billions of these conducting nanotubes 241 are collected together into a bundle. If the method of Z. Ren et al., *supra,* or any other similar method is used, then after the various depositions are performed it is a simple matter to slice or harvest the tubes from their substrate and create aligned sub-bundles or groups of them for further bundling and integration. If the outer conductor 247 of each conducting nanotube 241 is made of gold or other highly conductive material, then these conducting nanotubes 241 can be formed together into a bundle or group sub-bundle with the respective ends of the conducting nanotubes being connected together. For a large, very high power device a large macroscopic bundle can be used, shown for illustrative purposes at Figure 8A. Here a "hockey puck" type shape housing is shown for the collected bundle 251 of conducting nanotubes 241, since this is a common power device package. The pseudo P-channel enhancement mode power nanoswitch device 259 comprises the collective bundle 251 of conducting nanotubes 241 and an outer gating electrode band 250 which connects all the conductor portions 247 of all the conducting nanotubes 241 together to a first common terminal $G_1$. Conductive upper plate 258, shown lifted somewhat from contact with the conducting nanotube 251 bundle, and conductive lower plate 257 contact both the top and bottom surfaces and the exposed ends of both ends of the conducting nanotube 251 bundle. If the final diameter of the each conducting nanotube assembly as at Figure 7 is on the order of 60Å, then in a 4 inch diameter (100 mm.) diameter "puck" there will be a bundle area of $7.8 \times 10^{17}$ Å$^2$, requiring about $2.48 \times 10^{14}$ conducting nanotubes. If the resistance values of the nanotransistors of the prior art are accurate in that a conducting nanotube of usable length has an individual resistance on the order of a megohm ($10^6$ Ω), then this P-channel power nanoswitch has an ON resistance of $4.0 \times 10^{-7}$ Ω. For a conduction of one hundred thousand amperes ($10^5$ A), the voltage drop across the nanoswitch is then 0.04 V, a value far less than any comparable conventional solid state switching device can achieve, at only 4 KW power dissipation. Further, since the pseudo P-Channel enhancement mode power nanoswitch of the invention is symmetric it can be used with AC as well as DC current and has no "turn-off" latching problems, a feature not commonly found with silicon power switches. This pseudo P-channel power nanoswitch can thus be useful for power transmission and power conversion purposes.

Further, the gating slew rate of this device, to first order, would normally be expected to be extremely sharp, based on the characteristics of the individual conducting nanotubes 241. However, since the first gating terminal $G_1$ to the gating ring 250 is off-set from the conducting bundle 251, there will inherently be a lateral as well as radial asymmetry of the gating signal pulse transmission from first gating terminal $G_1$ of 250 to the individual members of the conducting nanotubes 241 across the entire device. This is shown at Figure 9A. Here the turn-on gating signal $G_1$ is realized to not have an infinite slew rate, but in practice a finite slew rate. A finite slew rate gating signal put to gating input gating ring 250 through first gating terminal $G_1$ must pass through the conductive material $247_1$ surrounding the most adjacent conducting nanotube members $241_1$. The turn-on gating signal is then transmitted to the next adjacent set of conducting nanotubes $241_2$ through their surrounding conductive material $247_2$, The gating signal put to first gating $G_i$ input to 250 is then transmitted to the next adjacent set of conducting nanotubes $241_3$ through their conductive materials $247_3$ and on to the most distal group of conducting nanotubes $241_4$ through the conductive material $247_4$. If the gating ring 250 is very highly conductive, then the grouping of the most electrically distal conducting nanotubes $241_4$ will be at the approximate center of the hockey puck package. Since the gating of the individual conducting nanotubes 241 involves the barrier material 243 there will always inherently be a capacitance between the conducting nanotube 241 and the first gating circuit to 250 and $G_1$. Thus there will always, inherently be an RC time constant delay between the application of a turn-on gating pulse to the external terminal $G_1$ of the gating circuit ring 250 and the transmission of the same to the various portions of the pseudo P-channel power nanoswitch assembly 259. Thus the extremely high slew rate which these nanoswitches can individually exhibit would be largely diluted by such practical gating RC time constant concerns.

However, the effects of the time constants of the invention can, through a judicious choice of threshold values of the various sections and groupings of the power nanoswitch nanotubes, be adjusted so that the switching threshold $V_{th1}$ of the conducting nanoswitch section $241_1$ most adjacent to the first input terminal $G_1$ has the highest threshold, the threshold of the next nearest conducting nanoswitch section $241_2$ has a lower switching threshold $V_{th2}$, etc., until the conducting nanoswitch section $241_4$ which is most electrically distal to the first input gating signal at $G_1$ will have the lowest threshold $V_{th4}$. In operation, a judicious choice for the finite gating voltage slew ramp will result in a simultaneous higher gating voltage at $241_1$ than at $241_2$, which will be greater than at $241_3$, which will be larger than at $241_4$ at one specific time. By judicious choice of the gating slew rate and/or gating slew rate shape and the various thresholds, all the individual nanotube sections will then fire at the exact same time. Additionally the gating slew rate and gating pulse shape can be adjusted for a particular device to minimize the time differentials between the various sections and thus optimize the device. While only four sections are shown here for illustrative purposes, it will be appreciated that any number of sections, hundreds or thousands, can be formed so that the gating RC time constant can be adjusted and compensated for to any degree desired. Thus the extremely high switching slew rate of the individual conducting nanotube switch can be preserved to any degree desired in the final pseudo P-channel power nanoswitch. This then forms a power switch having a conduction slew rate of unprecedented degree.

The gating threshold $V_{th}$ of the various sections can be controlled by any means known in the art, such as varying the thickness of the insulator, or any other means. If an insulator is chosen for the barrier material 243, then the insulator thickness can be changed from batch to batch, so that within a single batch it is uniform from end to end of any individual conducting nanotube 241, and uniform from individual conducting nanotube 241 to individual conducting nanotube 241 within that particular batch. By forming a plurality, perhaps hundreds or more, of separate batches of conducting nanotube switches with such different properties, a library of nanotube switches with their finely gradated thresholds can be created so that the engineer can design a nanotube power switch of predetermined properties and characteristics. Further, equivalent threshold voltage adjustment means can include the nanotube diameter. Other threshold adjustments include forming alloys of very finely divided and differentiated composition for the Schottky barrier material for the barrier material 243 to adjust the work function, $\phi_b$, and forming a library of these nanotube switches with their different thresholds.

Figure 9B shows a constant slew rate gating pulse for such a power device where RC time constant concerns are not inordinate and can adequately compensated for by varying the threshold values of the various nanotube groups $241_x$. However, for larger devices, such as the proposed 100mm. diameter device of Figure 8A, then a more shaped gating pulse can be used and in some cases is preferred. Here at Figure 9C the first part of the gating turn-on pulse has a very high slew rate drop from ground. This is so that the more distal portions can begin to be charged to bring the gating voltage up to almost the threshold voltage of the distal portions, thus "pre-charging" the more distal portions. After this very sharp drop in the gating pulse, the pulse drops more slowly to give the original portion of the pulse time to reach and charge the distal portions. The gating pulse is then chosen to drop to the adjacent group threshold $V_{thl}$ just as all the further groups reach their respective thresholds and thus the entire device switches ON simultaneously.

Such a power nanoswitch of Figure 8A can also be optimized for simultaneous turn-off, as illustrated at Fig.s 8B and 8C. Here, as at the second external gating input $G_2$ at Figure 9A, the groupings $241_4$ nearest the external turn-off terminal $G_2$ have the lowest threshold voltages $V_{th4}$ followed by the highest voltage threshold turn-off $V_{th1}$ at the most distal portions from the external gate turn off electrode $G_2$ of the device. In such a case, a turn-off gating pulse to such an optimized turn-off device would be preferably shaped as in Figure 9D where the initial rise of the gating pulse toward zero is sharp with a high initial slew rate to almost the threshold voltages of the most adjacent groups $241_4$ to allow transmission of the gating turn-off signal at $G_2$ to the most distal groups $241_1$ to begin to "pre-discharge" them, followed by a lower slew rate so that when the most adjacent groups $241_4$ of nanotubes turn-off all the other groupings to $241_1$ will turn-off as well simultaneously over the entire power nanodevice.

One of the problems of the carbon nanotube technology up to now has been the inability to easily manipulate and separate the nanotubes. Being highly conductive, they have a high van der Waals force and are much like sticky cooked spaghetti on a dry plate, sticking to themselves and to their substrate.

Thus another aspect of the invention is to provide apparati for separating and positioning the nanotubes or any other nanostructures into the desired positions, to a level of a few ~Å. For over a decade, through such breakthrough work by Kasanuki et al., U.S. Pat. 5,418,771 and Yanagisawa et al., U.S. Pat.s 5,519,686 and 5,721,721, and many others, the atomic recording and microscope technology has built and perfected apparati designs which enable probes to be positioned over an X-Y plane to within an atomic diameter of a desired position, a few ~Å. Thus not only can such recording/microscope probes be positioned to a positional accuracy of an atomic diameter in an X-Y plane by such apparati, but they can also have the probes rotated as desired. Depending upon the desired major end function of these apparati they are variously called a "scanning probe microscope" SPM, "scanning tunneling microscope" STM, "atomic force microscope" AFM, "near field optical microscope" NFOM, etc., or any other such similar acronym which describes the use of such apparati to accurately control probes of various types and functions to an X-Y positional accuracy of a few Å.

One aspect of the invention is to use this basic probe positioning apparati of the prior art and modify it, using novel probe designs and novel probe head designs, to perform an entirely new and unobvious function of that of a nanomanipulator and nanotransporter for nanotubes and any other nanostructure such as proteins and individual molecules.

Figure 10 shows a first embodiment of this transporter probe. Here an initial probe 281, similar in generally conical shape to the TEM probes, has a spiraled conductor 282 extending from an upper portion of the cone to the tip or a portion near the tip. The upper portion 283 of the spiraled conductor 282 is connected to a source of electrical current. The initial probe 281 is a conductor and a thin layer of insulating material 285 with an extremely low van der Waals force material, such as a polymerized fluorocarbon, is put over the initial probe 281. A spiral conductor can then either be wound upon the surface of the insulated probe or a metal deposited upon it and micromachined or etched into the spiral, pattern much like a metal film resistor. If wound, a nanotube can be used for the conductor due to their small size, great strength, and high conductivity. In either case, the spiraled conductor 282 can have a return conductor 284 applied to the side thereof. If a voltage is applied to conductive probe 281, then an electrostatic field is concentrated at 286 of the tip 287 and this can induce a switchable attractive force in nanomaterials, whether they be conductive or dielectric, below it. Also, if a current, including a time varying current, is placed to the spiraled conductor 282, a magnetic flux field 286 can also be generated, achieving a maximum just below the tip of the probe 287 at 286. This assures that a conductive nanostructure, such as a gold or solder nanoball, can be picked up and properly transported to the desired end location and then deposited as desired.

For long nanomaterials, such as a long nanotube, a second embodiment to the novel transportation probe assembly is shown at Figure 11. Here the initial chisel shaped, laterally elongated probe 291 having a generally "V" shaped cross section has correspondence to that of 281 in Figure 10, with spiral conductor 292, conductor source 293, and return conductor 294 corresponding to those 281, 283, and 284 of Figure 10, respectively. Here the electric field and/or magnetic field flux is concentrated at 298 under the entire elongated tip 297 in an elongated manner, rather than in a point manner as in Figure 10. The length of this chisel probe width is sized to approximate that of the desired carbon nanotube length. This probe assembly of Figure 11 can be used to pick up the nanotube or any other elongated conductive nanostructure for transportation and deposition to where ever desired. This probe is especially intended to be used with a rotation means similar to that of 1111, 1112 such as is disclosed in Kasanuki et al., *Ibid.* Using this rotator, a nanotube can be picked up with the length aligned with the length of the transportation probe 291 and then rotated into any other angular position desired for transportation or deposition at the final site.

In either of the embodiments of Figures 10 and 11 the current put to the spiral conductor 282, 292 can be DC, sinusoidal AC, or a triangular sawtooth, or any other such waveform having sufficient AC component. At low levels, an AC signal can be used to detect whether the nanostructure, such as a nanotube, has been properly attached to the probe by monitoring the "detuning" of the circuit, or in a "fine wire" Eddy current detection mode. For high AC levels, the probe can induce a repulsive force to throw the nanostructure to the substrate if it is conductive; if not, the nanostructure can be coated with a conductor, which can then be removed later, to achieve this repulsion. Thus a combination of electric and magnetic fields can attract, analyze, and deposit nanostructures of all kinds in a highly precise manner.

The inventor has also invented a method of solvating the nanotubes in a low van der Waals bath, such as fluorinated compounds, including fluorocarbons, to separate the tubes from each other and this forms an important part in the practical use of the invention. Even with a fluorocarbon solvent surrounding and separating a collection of nanotubes, however, there may be some sticking and there is still the problem of nanotube orientation.

Figure 12A shows a nanotube separator and alignment tank device 300. Here there is a tank 300 to be filled with a low van der Waals solvent such as a suitable fluorocarbon. The density and other properties of such a solvent-is chosen to be approximately that of the particular nanotubes or other nanostructures with the solvent coating each so as to provide a good suspension of the nanotubes throughout the solvent bath 301. The tank assembly 300 is preferred to be an elongated trough with a roughly triangular cross-section. At one side of the tank assembly 300 is an elongated acoustic transducer 303 which is capable of generating planar acoustic waves in the solvent bath 301. The proper choice of the tank 300 shape, the frequency of the signal generator 304, and the particular solvent in the bath will result in planar standing waves to be formed in the separation and alignment tank assembly 300. In operation, the nanotubes are suspended in their solution and the signal generator 304 tuned to the proper frequency and with an amplitude which will not break or degrade the nanotubes. If the suspension is of the proper density, then the agitation provided by the signal generator 304 and the transducer 303 will separate all the nanotubes and be sufficient to bring nanotubes up to the surface of the solvent bath 301. The action of the planar acoustic waves 305 will gently nudge the nanotube 302 which comes up to surface so that it will be in the lowest energy state being in that central node. Thus the nanotube, even if bent somewhat initially, will straighten and be perfectly aligned with the longitudinal direction of the solvent tank 300 at that central node, the lowest energy configuration for such a nanotube.

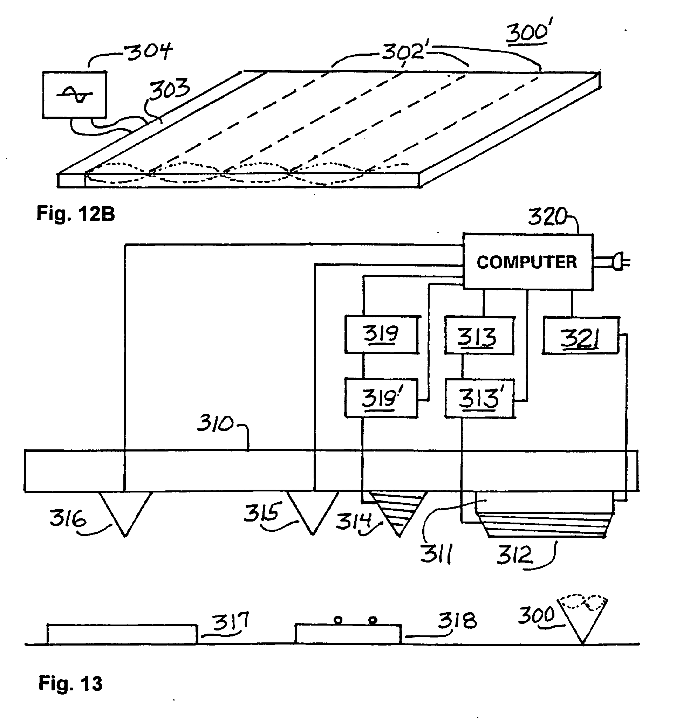

Figure 12B shows a variant of this separator and aligner with a rectangular acoustic plate 300' which is fed at one end by the planar acoustic transducer 303 and signal source 304 as in Figure 12A and works in a similar manner to form planar acoustic nodes 302' where the nanostructures will lie oriented along 302'. This aligner-separator of Figure 12B can be used for other purposes than the enablement of the disclosed invention as well, i.e. for forming structural designs such as an I-beam member.

The last aspect of the invention is combining all these features together to form a practical means of transporting and positioning the nanostructres, including nanotubes, into the final nanostructure, inbcluding circuitry, desired. As was previously suggested, the invention uses the recording and microscopy probe positioning apparati of the prior art such as of Kasanuki et al. and Yanagisawa et al. in an entirely new manner for such nanotube transportation and nanotube placement purposes. One such modified apparatus according to the invention is shown at Figure 13, which combines the multiprobe, extreme accuracy of the Yanagisawa et al. probe positioning and reference probe apparatus with the probe rotation apparatus of Kasanuki et al. Here is a multiprobe head assembly 310 which locks all the probes 316, 315, 314, and 312 into a rigid, stable alignment with each other. As is common in the art, all the probes here have a vertical positioning ability, which is entirely conventional and is not shown. The nanotube separation and alignment tank 300, or plate 300', keeps a supply of nanotubes or other nanostructures ready. If several different types or lengths of nanotubes are needed then there can be a plurality of such tanks 300, one for each type of nanotube; only one is illustrated here for simplicity.

The head assembly 310 can contain the elongated transportation probe 312 of Figure 11 and the associated rotation and vertical position mechanism 311, the conical transportation probe 314 of Figure 10, a standard STM probe 315, and a further reference encoding STM probe 316. As in Yanagisawa et al. the probe 316 provides a reference positioning encoding for the entire head assembly 310. By having the reference positioning probe 316 go over a suitable encoding positioning medium 317, the entire head assembly 310 can determine its position in an X-Y manner to a few Å, as is taught by Yanagisawa et al. The substrate 318 is the integrated nanotube substrate and preferably has an electron affinity, $\chi$, which is insufficient to deplete any nanotube which may be placed on it of its electrons and thus change its electrical characteristics; the substrate 318 still has sufficient van der Waals force to keep the nanotubes in their final position, however.

If there are a number of lengths of nanotubes to be placed, then there can be a plurality of elongated transportation probes 312 and their associated rotation means 311 on the head assembly 310, though only one is shown here for simplicity. The rotation mechanism 311 is controlled by rotation and vertical position circuit 321 which is controlled by a central computer 320. The transportation probe 314 is connected to sources of voltage and current 319' and to circuit monitors 319, as is head 312 with its associated sources and monitors 313', 313. Here one uses the "fine wire" Eddy current analysis in current sensor 313' to determine if only one nanotube has been properly attached, and attached properly lengthwise, to the elongated transportation probe 312 or not. If two nanotubes are mistakenly attached to the probe 312, then this will be indicated by the degree of detuning of the spiraled induction coil 292 of the transportation probe 312. The AC driving current can then be reduced, or otherwise adjusted, in an attempt of dropping one of the nanotubes.

The computer 315 then, after being satisfied that there is only one nanotube and that it is properly aligned with the transportation probe 312, and in conjunction with the encoding positional probe 316, moves the transportation probe 312 to the predetermined position over circuit substrate 318, rotates the nanotube to the desired angle, and then deposits the nanotube in the exact desired position and angle by lowering the head and releasing the nanostructure. If small nanoballs are needed for making ohmic connections, etc., then the conical transportation probe 314 can be used in a like manner.

The standard STM probe 315 is then run over the building up of the nanocircuit on substrate 318 to check for positional accuracy of the various nanotubes that have been placed so far. The standard STM probe 315 can then nudge the various nanotube assemblies back into proper alignment, as necessary. Further, as has been mentioned above, voltages ranging from 4 to 6.5 volts can be applied to the standard STM probe 315 to cut nanotubes, or a reduced voltage applied to clear unwanted dielectric and other coatings away in specific portions.

One further modification of this apparatus is if large numbers of a specific type of nanocircuit are to be built, then the reference medium 317 can have permanent markings put in it so that the apparatus can rapidly slew to the next position and then set up for the placement of the next elements. Further, this apparatus can be manually operated, or can be programmed to run unattended by itself through central computer 320, human intervention being necessary only for the filling of the various separation and alignment tanks 300, much as is done in conventional automobile manufacturing.

Thus it has been demonstrated that by using modifications to existing technology, in many cases using it for an entirely different and unobvious purpose, that nanostructures, such as nanotubes, can be made into N-channel and pseudo P-channel devices, that these can be combined on the same nanotube, that simple and complex logic gating and counting circuits can be constructed, and power devices of superior performance built easily. The invention, as stated above, is not limited to nanotubes and nanocircuits, but can include any nanostructure such as DNA, proteins, polymers, chemical molecules, etc., which need to be transported and arranged in a particular manner. Thus by using the teachings of the invention any practitioner is easily enabled to make and use the invention.

## INDUSTRIAL APPLICABILITY

The invention has applicability in electronics, instrumentation, computers, biology, medicine, chemistry, power distribution and conversion, and high strength structures suitable for aeronautical and space craft.

## Claims

1. An electronic nanodevice comprising:

    at least a first nanotube (151, 151') which is capable of conducting a current when a potential difference is applied to separated regions thereof; **characterized by**:

        at least a first gating structure (150) in conjunction with said at least a first nanotube at a first location for controlling the conduction current in said at least a first nanotube (151, 151'), said at least a first gating structure (150) and said at least a first nanotube (151, 151') having a first barrier (153, 153') between them sufficient to sustain a gating potential when applied to said at least a first gating structure to control said conduction current,
        said at least a first gating structure further comprising at least-one of:

            a. a second nanostructure (152) generally transverse to and crossing said at least a first nanotube (151) and having said first barrier (153) therebetween;
            and
            b. a third nanostructure (157) substantially surrounding at least a first portion of said at least a first nanotube (151') and having said first barrier (153') therebetween.

2. The nanodevice of claim 1 wherein said at least a first gating structure (150) comprises said second nanostructure which includes a second nanotube (152, 150'); and
    said first barrier (153, 153') comprises a material selected from one of a dielectric material, a Schottky material, and a semiconductor material, said first barrier being placed between said second nanotube (152, 150') and said at least a first nanotube (151, 151');
    wherein said second nanotube (152, 150') further includes one of a true metallic, metalloid, and semiconducting nanotube, and
    said first barrier material (153, 153') includes at least one of: $SiO_x$, $x < 2$; $SiO_2$; $SiO_2$:H; $SiO_2$:F; fused metal oxides; fluorocarbon polymers; Hf; Mg; W; Pt; Ir; Ni; Pd; Rh; Mo; Cr; Ti; V; Nb; Ru; Sb; Os; Ta; Ge; Se; GaAs/N+AlGaAs; Si; III-V semiconductors; II-VI semiconductors; and nanotube semiconductors.

3. The nanodevice of claim 1 wherein said at least a first gating structure (150, 157, 153') comprises said third nanostructure, said third nanostructure having an outer conductive surface (157), and
said first barrier (153') comprises a material selected from one of a dielectric material, a Schottky material, and a semiconductor material,
said first barrier (153') having a first electron affinity, $\chi_b$, sufficiently large such that said at least a first nanotube (151') is at least partially depleted of carriers at zero voltage bias applied to said outer conductive surface (157) of said at least a first gating structure;
said first barrier material (153') includes at least one of: $SiO_x$, $x < 2$; $SiO_2$; W; Pt; Ir; Ni; Pd; Rh; Mo; Cr; Ti; V; Nb; Ru; Sb; Os; Ta; Ge; Se; GaAs/N+AlGaAs; Si; III-V semiconductors; and II-VI semiconductors.

4. The nanodevice of claim 3 further comprising at least a second further gating structure (174, 177) substantially surrounding at least a second portion of said at least a first nanotube (171) at a second location and having a second outer conductive surface (177); and said at least a second further gating structure having a second barrier (174) comprising a material selected from one of a dielectric material, a Schottky material, and a semiconductor material,
said second barrier (174) having a second electron affinity, $\chi_{b2}$, insufficient to deplete the carriers of said at least a first nanotube(171) at zero voltage applied to said second outer conductive surface (177) of said at least a second further gating structure; wherein the thresholds of said at least a first gating structure and said at least a second further gating structure are set to the same voltage, said first outer conductive surface (177) and said second outer conductive surface (177) being electrically coupled together, a contact made to said first and second outer conductive surfaces for application of a signal input, and a contact made to said at least a first nanotube (171) between said first and second locations for a signal output, to thereby create a nanoinverter of the signal input;
wherein said second barrier (174) material includes at least one of: $SiO_2$:H; $SiO_2$:F; fused metal oxides; fluorocarbon polymers; Hf; Mg; III-V semiconductors; and II-VI semiconductors.

5. The nanodevice of claim 4 wherein there is at least a second nanotube nanoinverter (171', 174') of substantially identical construction to said at least a first nanotube nanoinverter (171, 174), both being on a common substrate, said at least a second nanotube nanoinverter being oriented at a 180° rotation to said at least a first nanotube nanoinverter, the two nanoinverters being thus antiparallel and spaced at a predetermined distance and longitudinally aligned such that said signal input (IN) of said at least a first nanotube nanoinverter is adjacent to the signal output (OUT) of said at least a second nanotube nanoinverter, the signal input of said at least a second nanotube nanoinverter being longitudinally aligned with said signal output of said at least a first nanotube nanoinverter; and connections (179, 179') made between the two nanotube nanoinverters between these aligned pairs of inputs and outputs to form at least a first nanomultivibrator;
arranged so that appropriate sources of potential may be applied to the free ends of said at least a first and second nanotube nanoinverters;
wherein at least one of such nanomultivibrators are formed on said common substrate in a given direction, the design of each nanomultivibrator being a mirror image of any adjacent nanomultivibrator along said given direction, the ends of all the nanotube nanoinverters of the adjacent nanomultivibrators of like sources of potential being grouped together in pairs for common connection; and
the signal output of one nanomulitvibrator being connected to the input of the adjacent nanomultivibrator along said given direction, to thereby form a frequency dividing chain circuit for said input signal.

6. The nanodevice of claim 3 wherein there are a plurality of said at least a first nanotubes (241),
said first barrier (243) and said outer conductive surface (247) of each of these plurality of nanotubes (241) being generally coextensive with the length of each of these nanotubes;
said plurality of nanotubes forming a bundle (251) and gating contact (G(1)) being made to said outer conductive surfaces of each of said plurality of nanotubes, said gating contact being connected externally to at least a first external gating terminal (250); and first and second conductive electrodes, said first conductive electrode (257) contacting the first ends of said plurality of nanotubes at one end of said bundle, and said second conductive electrode (258) contacting the second ends of said plurality of nanotubes at the other end of said bundle;
said first and second conductive electrodes being capable of being externally connected.

7. The nanodevice of claim 6,
arranged such that the threshold voltages of said plurality of nanotubes (241) vary by groups depending upon the electrical distance from said at least a first external gating terminal (250), groups of said plurality of nanotubes electrically closest to said first external gating terminal having the highest threshold voltage, and groups of said plurality of nanotubes electrically most distal to said first external gating terminal having the lowest threshold voltage;
and further arranged to compensate an RC time constant of propagation of a finite slew rate gating pulse put to said first external gating terminal by the variation in the threshold voltages of the various groups of said nanotubes (241) and a wave shape of the finite slew rate gating pulse and predetermined to switch ON the entire nanodevice (259) switches simultaneously over all said plurality of nanotubes from an initial OFF condition.

8. The nanodevice of claim 6 wherein,
said gating contact is connected externally to said at least a first external gating terminal (G$_1$) at a first location of said plurality of nanotubes and a further second gating contact of said plurality of nanotubes is connected externally to a second external gating terminal (G$_2$) at a location remote from said first external gating terminal;
wherein the threshold voltages of said plurality of nanotubes vary by groups depending upon the electrical distance from said at least a first external gating terminal (G$_1$) to said second external gating terminal (G$_2$), groups of said plurality of nanotubes electrically closest to said at least a first external gating terminal having the highest threshold voltage, and groups of said plurality of nanotubes electrically most distal to said at least a first external gating terminal being simultaneously closest to said second external gating terminal and having the lowest threshold voltage; and wherein an RC time constant of propagation of a finite slew rate gating pulse put to said first external gating terminal is compensated for by the variation in the threshold voltages of the various groups of said nanotubes and the wave shape of the finite slew rate gating pulse and Is predetermined for the entire nanodevice to switch all said plurality of nanotubes ON substantially simultaneously; and
further arranged for an RC time constant of propagation of a finite slew rate gating pulse put to said second external gating terminal to be compensated for by the variation in the threshold voltages of the various groups of said nanotubes and the wave shape of the finite slew rate gating pulse and is predetermined for the entire nanodevice to switch all said plurality of nanotubes OFF substantially simultaneously; and
further arranged for the variation of threshold voltages of the various groups of nanotubes and the waveshape of the finite slew rate gating pulses applied to said at least a first and said second external gating terminals to be predetermined for said nanodevice to switch substantially simultaneously over all said plurality of nanotubes in a quasi-optimized manner.

**Patentansprüche**

1. Elektronische Nanovorrichtung, die folgendes umfasst:

mindestens eine erste Nanoröhre (151, 151'), die einen Strom leiten kann, wenn eine Potentialdifferenz an voneinander getrennte Bereiche der Röhre angelegt wird,
**gekennzeichnet durch**:

mindestens eine erste Gating-Struktur (150) in Verbindung mit der genannten mindestens einen ersten Nanoröhre an einer ersten Position zur Steuerung des Leitungsstroms in der genannten mindestens einen ersten Nanoröhre (151, 151'), wobei die genannte mindestens eine erste Gating-Struktur (150) und die genannte mindestens eine erste Nanoröhre (151, 151') eine erste Barriere (153, 153') zwischensich aufweisen, die ausreicht, um ein Gating-Potential zu halten, wenn es an die genannte mindestens eine erste Gating-Struktur angelegt wird, um den genannten Leitungsstrom zu steuern;

wobei die genannte mindestens eine erste Gating-Struktur ferner mindestens eines der folgenden Elemente umfasst:

a) eine zweite Nanostruktur (152), die allgemein quer zu der genannten mindestens einen ersten Nanoröhre (151) ist und diese kreuztund dazwischen die genannte erste Barriere (153) aufweist;
oder
b) eine dritte Nanostruktur (157), welche im Wesentlichen zumindest einen ersten Abschnitt mindestens einer ersten Nanoröhre (151) umgibt und dazwischen die genannte erste Barriere (153') aufweist.

2. Elektronische Nanovorrichtung nach Anspruch 1, wobei die genannte mindestens eine erste Gating-Struktur (150) die genannte zweite Nanostruktur umfasst, die eine zweite Nanoröhre (152, 150') aufweist; und
wobei die genannte erste Barriere (153, 153') ein Material umfasst, das ausgewählt wird aus einem dielektrischen Material, einem Schottky-Material und einem Halbleitermaterial, wobei die genannte erste Barriere zwischen der genannten zweiten Nanoröhre (152, 150') und der genannten mindestens einen ersten Nanoröhre (151, 151') platziert wird;
wobei die genannte zweite Nanoröhre (152, 150') ferner eine echtmetallische, metallartige oder Halbleiter-Nanoröhre aufweist; und
wobei das genannte erste Barrierenmaterial (153, 153') mindestens einen der folgenden Stoffe auf-

weist: $SiO_x$, x < 2; $SiO_2$; $SiO_2$:H, $SiO_2$:F; Schmelz-metalloxide; Fluorkohlenstoffpolymere; If; Mg; W; Pt; Ir; Ni; Pd; Rh; Mo; Cr; Ti; V; Nb; Ru; Sb; Os; Ta; Ge; Se; GaAs/N+AlGaAs; Si; III-V Halbleiter; II-VI-Halbleiter und Nanoröhren-Halbleiter.

3. Nanovorrichtung nach Anspruch 1, wobei die genannte mindestens eine erste Gating-Struktur (150, 157, 153') die genannte dritte Nanostruktur umfasst, wobei die genannte dritte Nanostruktur eine äußereleitfähige Oberfläche (157) aufweist; und wobei die genannte erste Barriere (153') ein Material umfasst, das ausgewählt wird aus einem dielektrischen Material, einem Schottky-Material und einem Halbleitermaterial; wobei die genannte erste Barriere (153') eine erste Elektronenaffinität aufweist, die ausreichend hoch ist, so dass die genannte mindestens eine erste Nanoröhre (151') zumindest teilweise erschöpft ist von Trägem bei einer Null-Volt-Vorspannung, die an die genannte äußere leitfähige Oberfläche (157) der genannten mindestens einen ersten Gating-Struktur angelegt wird; wobei das genannte erste Barrierenmaterial (153') mindestens einen der folgenden Stoffe aufweist: $SiO_x$, x < 2; $SiO_2$; W; Pt; Ir; Ni; Pd; Rh; Mo; Cr; Ti; V; Nb; Ru; Sb; Os; Ta; Ge; Se; GaAs/N+AlGaAs; Si; III-V Halbleiter; und II-VI-Halbleiter.

4. Nanovorrichtung nach Anspruch 3, wobei diese ferner mindestens eine zweite weitere Gating-Struktur (174, 177) umfasst, welche im Wesentlichen zumindest einen zweiten Abschnitt der genannten mindestens einen ersten Nanoröhre (171) an einer zweiten Position umgibt und eine zweite äußereleitfähige Oberfläche (177) aufweist; und wobei die genannte mindestens eine zweite weitere Gating-Struktur eine zweite Barriere (174) aufweist, die ein Material umfasst, das ausgewählt wird aus einem dielektrischen Material, einem Schottky-Material und einem Halbleitermaterial, wobei die genannte zweite Barriere (174) eine zweite Elektronenaffinität aufweist, die nicht ausreicht, um die Träger der genannten mindestens einen ersten Nanoröhre (171) bei einer an die genannte zweite äußereleitfähige Oberfläche (177) der genannten mindestens einen zweiten weiteren Gating-Struktur angelegten Nullspannung zu erschöpfen; wobei die Schwellenwerte der genannten mindestens einen ersten Gating-Struktur und der genannten mindestens einen zweiten weiteren Gating-Struktur auf die gleiche Spannung festgelegt sind, wobei die genannte erste äußere leitfähige Oberfläche (177) und die genannte zweite äußere leitfähige Oberfläche (177) elektrisch miteinander gekoppelt sind, wobei ein Kontakt mit den genannten ersten und zweiten äußeren leitfähigen Oberflächen zum Anlegen eines Signaleingangs hergestellt wird, und wobei ein Kontakt mit der genannten mindestens einen ersten Nanoröhre (171) zwischenden genannten ersten und zweiten Positionen für einen Signalausgang hergestellt wird, wodurch ein Nanoinverter des Signaleingangs erzeugt wird; wobei das Material der genannten zweiten Barriere (174) mindestens einen der folgenden Stoffe aufweist: $SiO_2$:H, $SiO_2$:F; Schmelzmetalloxide; Fluorkohlenstoffpolymere; Hf; Mg; III-V Halbleiter; und II-VI-Halbleiter.

5. Nanovorrichtung nach Anspruch 4, wobei mindestens ein zweiter Nanoröhren-Nanoinverter (171', 174') mit im Wesentlichen der gleichen Konstruktion wie der genannte mindestens eine Nanoröhren-Nanoinverter (171, 174) vorgesehen ist, wobei diese sich beide auf einem gemeinsamen Substrat befinden, wobei der genannte mindestens eine zweite Nanoröhren-Nanoinverter um 180° gedreht zu dem genannten mindestens einen ersten Nanoröhren-Nanoinverter ausgerichtet ist, wobei die beiden Nanoinverter somit antiparallel und mit einem vorbestimmten Abstand zueinander sowie longitudinal ausgerichtet sind, so dass sich der genannte Signaleingang (IN) des genannten mindestens einen ersten Nanoröhren-Nanoinverters angrenzend an den Signalausgang (OUT) des genannten mindestens einen zweiten Nanoröhren-Nanoinverters angeordnet befindet, wobei der Signaleingangdes genannten mindestens einen zweiten Nanoröhren-Nanoinverters longitudinal ausgerichtet ist mit dem genannten Signalausgang des genannten mindestens einen ersten Nanoröhren-Nanoinverters; und wobei Verbindungen (179, 179') hergestellt werden zwischenden beiden Nanoröhren-Nanoinvertern zwischendiesen ausgerichteten Paaren von Eingängen und Ausgängen, so dass mindestens ein erster Nanomultivibrator gebildet wird;

mit einer Anordnung, so dass entsprechend geeignete Potentialquellen an die dreien Enden der genannten mindestens einen ersten und zweiten Nanoröhren-Nanoinverter angelegt werden können; wobei der mindestens eine der Nanomultivibratoren auf dem genannten gemeinsamen Substrat in einer bestimmten Richtung ausgebildet ist, wobei es sich bei der Konstruktion jedes Nanomultivibrators um ein Spiegelbild jedes benachbarten Nanomultivibrators entlang der genannten bestimmten Richtung handelt, wobei die Enden aller Nanoröhren-Nanoinverter der benachbarten Nanomultivibratoren gleicher Potentialquellen zur gemeinsamen Verbindung in Paarenzusammengefasst sind; und wobei der Signalausgang eines Nanomultivibrators mit dem Eingang des benachbarten Nanomultivibrators entlang der genannten bestimmten Richtung verbunden ist, um **dadurch** eine frequenzteilende Kettenschaltung für das genannte Eingangssignal zu bilden.

**6.** Nanovorrichtung nach Anspruch 3, wobei eine Mehrzahl der genannten mindestens einen ersten Nanoröhren (241) vorgesehen ist;
wobei die genannte erste Barriere (243) und die genannte äußere leitfähige Oberfläche (247) jeder Röhre dieser Mehrzahl von Nanoröhren (241) sich allgemein über die gleiche Länge erstreckt wie die Länge jeder dieser Nanoröhren;
wobei die genannte Mehrzahl von Nanoröhren ein Bündel (251) bildet, und wobei ein Gating-Kontakt (G(1)) mit den genannten äußeren leitfähigen Oberflächen jeder Röhre der genannten Mehrzahl von Nanoröhren hergestellt wird, wobei der genannte Gating-Kontakt extern mit mindestens einem ersten externen Gating-Anschluss (250) verbunden ist; und mit ersten und zweiten leitfähigen Elektroden, wobei die genannte erste leitfähige Elektrode (257) die ersten Enden der genannten Mehrzahl von Nanoröhren an einem Ende des genannten Bündels berührt, und wobei die genannte zweite leitfähige Elektrode (258) die zweiten Enden der genannten Mehrzahl von Nanoröhren an dem anderen Ende des genannten Bündels berührt;
wobei die genannten ersten und zweiten leitfähigen Elektroden extern verbunden werden können.

**7.** Nanovorrichtung nach Anspruch 6,
die so angeordnet ist, dass die Schwellenspannungen der genannten Mehrzahl von Nanoröhren (241) nach Gruppen abhängig von dem elektrischen Abstand von dem genannten mindestens einen ersten externen Gating-Anschluss (250) variieren, wobei die Gruppen der genannten Mehrzahl von Nanoröhren, die elektrisch am nächsten an dem genannten ersten externen Gating-Anschluss angeordnet sind, die höchste Schwellenspannung aufweisen, und wobei die Gruppen der genannten Mehrzahl von Nanoröhren, die elektrisch am weitesten von dem genannten ersten externen Gating-Anschluss entfernt angeordnet sind, die niedrigste Schwellenspannung aufweisen;
und wobei die Nanovorrichtung ferner so angeordnet ist, dass sie eine RC-Zeitkonstante der Ausbreitung eines Gating-Impulses mit finiter Anstiegsgeschwindigkeit, der dem genannten ersten externen Gating-Anschluss zugeführt wird, kompensiert um die Abweichung der Schwellenspannungen der verschiedenen Gruppen der genannten Nanoröhren (241), und einer Wellenform des Gating-Impulses mit finiter Anstiegsgeschwindigkeit, und vorbestimmt, so dass alle Schalter der Nanovorrichtung (259) gleichzeitig über alle Röhren der genannten Mehrzahl von Nanoröhren aus einem ausgeschalteten Ausgangszustand OFF in ON eingeschaltet werden.

**8.** Nanovorrichtung nach Anspruch 6, wobei:

der genannte Gating-Kontakt extern an einer ersten Position der genannten Mehrzahl von Nanoröhren mit dem genannten mindestens einen ersten externen Gating-Anschluss (G$_1$) verbunden ist, und wobei ein weiterer zweiter Gating-Kontakt der genannten Mehrzahl von Nanoröhren extern an einer Position, die von dem genannten ersten externen Gating-Anschluss entfernt ist, mit einem zweiten externen Gating-Anschluss (G$_2$) verbunden ist;

wobei die Schwellenspannungen der genannten Mehrzahl von Nanoröhren nach Gruppen abhängig von dem elektrischen Abstand von dem genannten mindestens einen ersten externen Gating-Anschluss (G$_1$) zu dem genannten zweiten externen Gating-Anschluss (G$_2$) variieren, wobei die Gruppen der genannten Mehrzahl von Nanoröhren, die elektrisch am nächsten an dem genannten mindestens einen ersten externen Gating-Anschluss angeordnet sind, die höchste Schwellenspannung aufweisen, und wobei die Gruppen der genannten Mehrzahl von Nanoröhren, die elektrisch am weitesten von dem genannten mindestens einen ersten externen Gating-Anschluss entfernt angeordnet sind, gleichzeitig am nächsten an dem genannten zweiten externen Gating-Anschluss angeordnet sind und die niedrigste Schwellenspannung aufweisen;
und wobei eine RC-Zeitkonstante der Ausbreitung eines Gating-Impulses mit finiter Anstiegsgeschwindigkeit, der dem genannten ersten externen Gating-Anschluss zugeführt wird, kompensiert wird durch die Abweichung der Schwellenspannungen der verschiedenen Gruppen der genannten Nanoröhren und der Wellenform des Gating-Impulses mit finiter Anstiegsgeschwindigkeit, und vorbestimmt, so dass die ganze Nanovorrichtung im Wesentlichen gleichzeitig alle Röhren der genannten Mehrzahl von Nanoröhren in ON einschaltet; und
ferner mit einer Anordnung für eine Kompensation einer RC-Zeitkonstante der Ausbreitung eines Gating-Impulses mit finiter Anstiegsgeschwindigkeit, der dem genannten zweiten externen Gating-Anschluss zugeführt wird, durch die Abweichung der Schwellenspannungen der verschiedenen Gruppen der genannten Nanoröhren und der Wellenform des Gating-Impulses mit finiter Anstiegsgeschwindigkeit, und vorbestimmt, so dass die ganze Nanovorrichtung im Wesentlichen gleichzeitig alle Röhren der genannten Mehrzahl von Nanoröhren in OFF ausschaltet; und
ferner mit einer Anordnung für die Vorbestimmung der Abweichung der Schwellenspannungen der verschiedenen Gruppen von Nanoröhren und der Wellenform des Gating-Impulses mit finiter Anstiegsgeschwindigkeit, der dem genannten mindestens einen ersten externen Gating-Anschluss und dem genannten zweiten externen Gating-Anschluss zugeführt wird, so dass die genannte Nanovorrichtung im Wesentlichen gleichzeitig über alle Röhren der genannten Mehrzahl von Nanoröhren auf eine quasioptimierte Art und Weise schaltet.

**Revendications**

1. Nanodispositif électronique comprenant :

au moins un premier nanotube (151, 151') qui est capable de conduire un courant lorsqu'une différence de potentielest appliquée à des régions distinctes de celui-ci ;

**caractérisé par** :

au moins une première structure de déclenchement (150) en rapport avec ledit au moins un premier nanotube à un premier emplacement pour contrôler le courantde conduction dans ledit au moins un premier nanotube (151, 151'), ladite au moins une première structure de déclenchement (150) et ledit au moins un premier nanotube (151, 151') ayant une première barrière (153, 153') entre eux suffisante pour entretenir un potentielde déclenchement en cas d'application au moins une première structure de déclenchement pour contrôler ledit courantde conduction,

ladite au moins une première structure de déclenchement comprenant en outre au moins l'une :

a. d'une seconde nanostructure (152) généralement transverse à et traversant ledit au moins un premier nanotube (151) et ayant ladite première barrière (153) entre eux ;
et
b. d'une troisième nanostructure (157) entourant sensiblement au moins une première partie dudit au moins un premier nanotube (151') et ayant ladite première barrière (153') entre elles.

2. Nanodispositif selon la revendication 1, dans lequel ladite au moins une première structure de déclenchement (150) comprend ladite seconde nanostructure qui comprend un second nanotube (152, 150') ; et
ladite première barrière (153, 153') comprend un matériau choisi entre l'un d'un matériau diélectrique, d'un matériau Schottky et d'un matériau semi-conducteur, ladite première barrière étant placée entre ledit second nanotube (150, 150') et ledit au moins un premier nanotube (151, 151') ;
dans lequel ledit second nanotube (152, 150') comprend en outre l'un d'un véritable nanotube métallique, métalloïde et semi-conducteur, et
le matériau de ladite première barrière (153, 153') comprend au moins l'un de :
$_2$ X < 2 ; $SiO_2$ ; $SiO_2$ : H ; $SiO_2$ : F ; oxydes métalliques fondus ; polymères fluorocarbonés ; Hf ; Mg ; W ; Pt ; Ir ; Ni ; Pd ; Rh ; Mo ; Cr ; Ti ; V ; Nb ; Ru ; Sb ; Os ; Ta ; Ge ; Se ; GaAs/N+AlGaAs ; Si ; semi-conducteurs III-V ; semi-conducteurs II-VI ; et semi-conducteurs à nanotube.

3. Nanodispositif selon la revendication 1, dans lequel ladite au moins une première structure de déclenchement (150, 157, 153') comprend ladite troisième nanostructure, ladite troisième nanostructure ayant une surface conductrice extérieure (157), et
ladite première barrière (153') comprend un matériau choisi entre l'un d'un matériau diélectrique, d'un matériau Schottky et d'un matériau semi-conducteur,
ladite première barrière (153') ayant une première affinité électronique, , suffisamment grande pour que ledit au moins un premier nanotube (151') soit au moins partiellement appauvrien porteurs de charge à une polarisationde tension zéro appliquée à ladite surface conductrice extérieure (157) de ladite au moins une première structure de déclenchement ;
le matériau de ladite première barrière (153') comprend au moins l'un de : x < 2; $SiO_2$; W; Pt; Ir; Ni ; Pd ; Rh ; Mo ; Cr ; Ti ; V ; Nb ; Ru ; Sb ; Os ; Ta ; Ge ; Se ; GaAs/N+AlGaAs ; Si ; semi-conducteurs III-V et semi-conducteurs II-VI.

4. Nanodispositif selon la revendication 3 comprenant en outre au moins une seconde autre structure de déclenchement (174, 177) entourant sensiblement au moins une seconde partie dudit au moins un premier nanotube (171) à un second emplacement et ayant une seconde surface conductrice extérieure (177) ; et
ladite au moins une seconde autre structure de déclenchement ayant une second barrière (174) comprenant un matériau choisi entre l'un d'un matériau diélectrique, d'un matériau Schottky et d'un matériau semi-conducteur,
ladite seconde barrière (174) ayant une seconde affinité électronique, , insuffisante pour appauvrir les porteurs de charge dudit au moins un premier nanotube (171) à la tension zéro appliquée à ladite seconde surface conductrice extérieure (177) de ladite au moins une seconde autre structure de déclenchement ; dans lequel les seuils de ladite au moins une première structure de déclenchement et de ladite au moins une seconde autre structure de déclenchement sont fixés à la même tension, ladite première surface conductrice extérieure (177) et ladite seconde surface conductrice extérieure (177) étant électriquement couplées ensemble, un contact étant fait auxdites première et seconde surfaces conductrices extérieures pour l'application d'une entrée de signal, et un contact étant fait audit au moins un premier nanotube (171) entre lesdits premier et second emplacements pour une sortie de signal, pour ainsi créer un nanoinverseur de l'entrée de signal ; dans lequel le matériau de ladite seconde barrière (174) comprend au moins l'un de : $SiO_2$ : H ; $SiO_2$ : F ; oxydes métalliques fondus ; polymères fluorocarbonés ; Hf ; Mg ; semi-conducteurs III-V ; et semi-conducteurs II-VI.

5. Nanodispositif selon la revendication 4, dans lequel il y a au moins un second nanoinverseur à nanotube (171', 174') d'une construction sensiblement identique audit au moins un premier inverseur à nanotube (171, 174), les deux étant sur un substrat commun, ledit au moins un second nanoinverseur à nanotube étant orienté à une rotation de 180 °C par rapport audit au moins un premier nanoinverseur à nanotube, les deux nanoinverseurs étant ainsi antiparallèles et espacés d'une distance prédéterminée et alignés longitudinalement de sorte que ladite entrée de signal (IN) dudit au moins un premier nanoinverseur à nanotube soit adjacente à la sortie de signal (OUT) dudit au moins un second nanoinverseur à nanotube, l'entrée de signal dudit au moins un second nanoinverseur à nanotube étant longitudinalement alignée avec ladite sortie de signal dudit au moins un premier nanoinverseur à nanotube ; et des connexions (179, 179') étant faites entre les deux nanoinverseurs à nanotube entre ces paires alignées d'entrées et de sorties pour former au moins un premier nanomultivibrateur ; agencé de sorte que des sources appropriées de potentiel puissent être appliquées aux extrémités libres desdits au moins un premier et second nanoinverseurs à nanotube ; dans lequel au moins l'un de tels nanomultivibrateurs est formé sur ledit substrat commun dans une direction donnée, la conception de chaque nanomultivibrateur étant une image miroir de tout nanomultivibrateur adjacent le long de toute direction donnée, les extrémités de tous les nanoinverseurs à nanotube des nanomultivibrateurs adjacents à sources de potentiel similaires étant groupées ensemble en paires pour une connexion commune ; et la sortie de signal d'un nanomultivibrateur étant connectée à l'entrée du nanomultivibrateur adjacent le long de ladite direction donnée, pour ainsi former un circuit en chaîne à division de fréquence pour ledit signal d'entrée.

6. Nanodispositif selon la revendication 3, dans lequel il y a une pluralité desdits au moins un premier nanotube (241), ladite première barrière (243) et ladite surface conductrice extérieure (247) de chacun de cette pluralité de nanotubes (241) étant généralement coextensive avec la longueur de chacun de ces nanotubes ; ladite pluralité de nanotubes formant un faisceau (251) et un contact de déclenchement (G(1)) étant fait avec lesdites surfaces conductrices extérieures de chacun de ladite pluralité de nanotubes, ledit contact de déclenchement étant connecté extérieurement à au moins une première borne de déclenchement externe (250) ; et des première et seconde électrodes conductrices, ladite première électrode conductrice (257) étant en contact avec les premières extrémités de ladite pluralité de nanotubes à une extrémité dudit faisceau, et ladite seconde électrode conductrice (258) étant en contact avec les secondes extrémités de ladite pluralité de nanotubes à l'autre extrémité dudit faisceau ; lesdites première et seconde électrodes conductrices pouvant être connectées extérieurement.

7. Nanodispositif selon la revendication 6, agencé de telle sorte que les tensions seuils de ladite pluralité de nanotubes (241) varient par groupes en fonction de la distance électrique depuis ladite au moins une première borne de déclenchement externe (250), les groupes de ladite pluralité de nanotubes électriquement les plus près de ladite première borne de déclenchement externe ayant la tension seuil la plus élevée, et les groupes de ladite pluralité de nanotubes électriquement les plus éloignés de ladite première borne de déclenchement externe ayant la tension seuil la plus basse ; et agencé en outre pour compenser une constante de temps RC de propagation d'une impulsion de déclenchement à vitesse de balayage finie transmise à ladite première borne de déclenchement externe par la variation dans les tensions seuils des divers groupes desdits nanotubes (241) et une forme d'onde de l'impulsion de déclenchement à vitesse de balayage finie et prédéterminée pour mettre sous tension tous les commutateurs du nanodispositif (259) simultanément sur toute ladite pluralité de nanotubes à partir d'une condition hors tension initiale.

8. Nanodispositif selon la revendication 6, dans lequel ledit contact de déclenchement est connecté extérieurement à ladite au moins une première borne de déclenchement externe ($G_1$) à un premier emplacement de ladite pluralité de nanotubes et un autre second contact de déclenchement de ladite pluralité de nanotubes est connecté extérieurement à une seconde borne de déclenchement externe ($G_2$) à un emplacement distant de ladite première borne de déclenchement externe ; dans lequel les tensions seuils de ladite pluralité de nanotubes varient par groupes en fonction de la distance électrique à partir de ladite au moins une première borne de déclenchement externe ($G_1$) vers ladite seconde borne de déclenchement externe

(G$_2$), les groupes de ladite pluralité de nanotubes électriquement les plus près de ladite au moins une première borne de déclenchement externe ayant la tension seuil la plus élevée, et les groupes de ladite pluralité de nanotubes électriquement les plus éloignés de ladite au moins une première borne de déclenchement externe étant simultanément les plus près de ladite seconde borne de déclenchement externe et ayant la tension seuil la plus basse ;

et dans lequel une constante de temps RC de propagation d'une impulsion de déclenchement à vitesse de balayage finie transmise à ladite première borne de déclenchement externe est compensée par la variation dans les tensions seuils des divers groupes desdits nanotubes et la forme d'onde de l'impulsion de déclenchement à vitesse de balayage finie et est prédéterminée pour le nanodispositif en entier pour mettre sous tension toute ladite pluralité de nanotubes sensiblement simultanément ; et

en outre agencé pour qu'une constante de temps RC de propagation d'une impulsion de déclenchement à vitesse de balayage finie transmise à ladite seconde borne de déclenchement externe soit compensée par la variation dans les tensions seuils des divers groupes desdits nanotubes et la forme d'onde de l'impulsion de déclenchement à vitesse de balayage finie et prédéterminée pour le nanodispositif en entier pour mettre hors tension toute ladite pluralité de nanotubes sensiblement simultanément ; et

agencé en outre pour que la variation des tensions seuils des divers groupes de nanotubes et la forme d'onde des impulsions de déclenchement à vitesse de balayage finie appliquée à ladite au moins une première et ladite seconde bornes de déclenchement externes soit prédéterminée pour que ledit nanodispositif commute sensiblement simultanément toute ladite pluralité de nanotubes d'une façon quasi-optimisée.

**Fig. 5D**

**Fig. 1A   Prior Art**

**Fig. 1B   Prior Art**

**Fig. 2A**

Fig. 2B

Fig. 2C

Fig. 3A

Fig. 3B

**Fig. 4A**

**Fig. 4B**

**Fig. 3C**

**Fig. 4C**

**Fig. 4D**

**Fig. 5A**

**Fig. 5B**

**Fig. 5C**

Fig. 6B

Fig. 5E

Fig. 6A

**Fig. 10**

**Fig. 11**

**Fig. 7**

**Fig. 8A**

259'

$G'_2$

258'

$G'_1$

250'

257'

**Fig. 8B**

259"

258"

$G''_1$    $G''_2$

256"

251"

250"

257"

**Fig. 8C**

0    t

$-V$

$V_G$

**Fig. 9B**

0    t

$-V_{th}$    $V_{G1}$

$-V$

**Fig. 9C**

0    t

$V_{G2}$

$-V$

**Fig. 9D**

302

305

303

301

300

304

**Fig. 12A**

0    $-V_G$    $247_1$    $247_2$    $247_3$    $247_4$    0    $-V_G$

$G_1$    $G_2$

$241_1$    $241_2$    $241_3$    $241_4$

**Fig. 9A**

**Fig. 12B**

**Fig. 13**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 1877140 A, Lilienfeld
- US 5418771 A, Kasanuki
- US 5519686 A, Yanagisawa
- US 5721721 A
- JP 07122198 B

### Non-patent literature cited in the description

- *Electronic Engineering Times,* 16 November 1998, 67
- **S. Tans et al.** *Nature,* 03 April 1997, 474-477
- *NATURE,* 07 May 1998, 49-52
- *NATURE,* 20 August 1998, 761-764
- **R. Martel et al.** *Applied Physics Letters,* 26 October 1998, 2447-2449
- **A. Hassanien et al.** *Applied Physics Letters,* 28 December 1998, 3839-3841
- **L. Venema et al.** *Applied Physics Letters,* 03 November 1997, 2629-2631
- **Z. Ren et al.** *Science,* 06 November 1998, 1105-1107
- **J. Gondermann et al.** *Microelectronic Engineering,* 1997, vol. 35, 305-308
- **M. Dresselhaus et al.** Science of Fullerenes and Carbon Nanotubes. Academic Press, 1996
- **W. Scott.** The Physics of Electricity and Magnetism. Wiley, 1966, 163-165
- **L. Venema et al.** Length control of individual carbon nanotubes by nanostructuring with a scanning tunneling microscope. *Applied Physics Letters,* 03 November 1997, vol. 71 (18), 2629-2631
- **Z. Ren et al.** Synthesis of Large Arrays of Well-Aligned Carbon Nanotubes on Glass. *Science,* 06 November 1998, vol. 282 (5391), 1105-1107